# EUROPEAN PATENT APPLICATION

(11) **EP 4 535 971 A1**
(43) Date of publication of application: **09.04.2025**
(21) Application number: 24203898.2
(22) Date of filing: 01.10.2024
(51) Int. Cl.: H10K 59/131, H10K 59/65

(54) **DISPLAY DEVICE AND ELECTRONIC DEVICE HAVING THE SAME**

(30) Priority: 05.10.2023 KR 20230132552
(71) Applicant: Samsung Display Co., Ltd., Gyeonggi-do 17113 (KR)
(72) Inventor: SONG, Hee Rim, 17113 Yongin-si, Gyeonggi-do (KR); JEON, Mu Kyung, 17113 Yongin-si, Gyeonggi-do (KR); LEE, Kyung Hoe, 17113 Yongin-si, Gyeonggi-do (KR); LEE, Cheol Gon, 17113 Yongin-si, Gyeonggi-do (KR)
(74) Representative: Gulde & Partner

(57) **Abstract**

A display device includes: a display panel including: a display area including a sub-pixel; and a sensing area including an optical sensor to provide a sensing signal corresponding to an amount of received light to a readout line; a readout circuit to receive the sensing signal through the readout line; and a connection portion electrically connecting the readout line to the readout circuit. The display area includes the sensing area including the sub-pixel and the optical sensor, and a non-sensing area including the sub-pixel. A connection line connecting the readout line and the connection portion to each other is located in the non-sensing area.

## Description

### BACKGROUND

### 1. Field

Aspects of embodiments of the present disclosure relate to a display device including an optical sensor, and an electronic device having the same.

### 2. Description of the Related Art

As information technology has developed, the importance of a display device, which is a connection medium between a user and information, has been highlighted. Accordingly, the use of display devices, such as a liquid crystal display device, an organic light emitting display device, and the like, has been increasing. In addition, the display device may sense the user's fingerprint using an optical sensor, and may perform a user authentication function.

The above information disclosed in this Background section is for enhancement of understanding of the background of the present disclosure, and therefore, it may contain information that does not constitute prior art.

### SUMMARY

One or more embodiments of the present disclosure may be directed to a display device that connects a readout line and a connection portion to each other through a connection line disposed in a non-sensing area.

One or more embodiments of the present disclosure may be directed to an electronic device including the display device.

According to one or more embodiments of the present disclosure, a display device includes: a display panel including: a display area including a sub-pixel; and a sensing area including an optical sensor configured to provide a sensing signal corresponding to an amount of received light to a readout line; a readout circuit configured to receive the sensing signal through the readout line; and a connection portion electrically connecting the readout line to the readout circuit. The display area includes the sensing area including the sub-pixel and the optical sensor, and a non-sensing area including the sub-pixel. A connection line connecting the readout line and the connection portion to each other is located in the non-sensing area.

In an embodiment, the readout line may extend in a first direction; the display area may include a first display area adjacent to the connection portion in the first direction, and a second display area; and the connection line may connect the readout line of the second display area to the connection portion.

In an embodiment, the readout line may extend in a first direction; the connection line may include a first connection line and a second connection line; the first connection line may extend in a second direction crossing the first direction, and may be connected to the readout line through a first line contact hole; and the second connection line may extend in the first direction, and may be connected to the first connection line through a second line contact hole.

In an embodiment, the first connection line and the second connection line may form a mesh structure.

In an embodiment, the connection line may further include a third connection line and a fourth connection line; the third connection line may extend in the second direction, and may be connected to the second connection line through a third line contact hole; and the fourth connection line may extend in the first direction, and may be connected to the third connection line through a fourth line contact hole.

In an embodiment, the readout line may be located at the same layer as that of the second connection line.

In an embodiment, the first connection line may be located at the same layer as that of the third connection line.

In an embodiment, the connection portion may include a first connection area, and a second connection area spaced from the first connection area; the readout line may extend in a first direction; the display area may include a first display area adjacent to the first connection area and the second connection area in the first direction, and a second display area; and the connection line may connect the readout line of the second display area to the connection portion.

In an embodiment, a width of a first end of the connection portion adjacent to the display area may be longer than a width of a second end of the connection portion connected to the readout circuit.

In an embodiment, the sub-pixel may include a light emitting element and a pixel driving circuit; the optical sensor may include a light receiving element and a sensor driving circuit; the sensing area may include a first area including the pixel driving circuit, and a second area adjacent to the first area and including the sensor driving circuit; and the non-sensing area may include the first area including the pixel driving circuit, and a third area adjacent to the first area.

In an embodiment, the pixel driving circuit may include a first pixel transistor configured to generate a driving current; the first pixel transistor may include a portion of a conductive pattern; and a width of the conductive pattern in the third area may be wider than a width of the conductive pattern in the second area.

In an embodiment, the pixel driving circuit may include a second pixel transistor configured to write a data voltage in response to a write gate signal; the second pixel transistor may include a portion of a conductive pattern; and a width of the conductive pattern in the third area may be wider than a width of the conductive pattern in the second area.

In an embodiment, the pixel driving circuit may include a storage capacitor configured to store a data voltage; the storage capacitor may include a portion of a conductive pattern; and at least a portion of the conductive pattern may be located in the third area.

In an embodiment, the sensor driving circuit may be configured to be initialized with a reset voltage; and a conductive pattern configured to receive the reset voltage may overlap with at least a portion of the readout line.

In an embodiment, at least a portion of the conduction pattern configured to receive the reset voltage may overlap with the first area.

In an embodiment, the conductive pattern configured to receive the reset voltage may have a mesh structure.

In an embodiment, the pixel driving circuit may be configured to receive a data voltage through a data line; the sensor driving circuit may be configured to receive a reset voltage through a reset voltage line; and the reset voltage line may be located between the data line and the readout line in the third area.

In an embodiment, a width of the connection line may increase as a length of the connection line increases.

According to one or more embodiments of the present disclosure, a display device includes: a display panel including: a display area including sub-pixels; and a sensing area including an optical sensor configured to provide a sensing signal corresponding to an amount of received light to a readout line; a readout circuit configured to receive the sensing signal through the readout line; a first connection portion electrically connecting the readout line to the readout circuit; and a second connection portion electrically connecting the readout line to the readout circuit, and spaced from the first connection portion. The display area includes the sensing area including some of the sub-pixels and the optical sensor, and a non-sensing area including others of the sub-pixels. A connection line connecting the readout line and the first connection portion and the second connection portion to each other may be located in the non-sensing area.

According to one or more embodiments of the present disclosure, an electronic device includes: a processor configured to provide input image data to a display device; the display device configured to display an image based on the input image data; and a power supply configured to supply power to the display device. The display device includes: a display panel including: a display area including a sub-pixel; and a sensing area including an optical sensor configured to provide a sensing signal corresponding to an amount of received light to a readout line; a readout circuit configured to receive the sensing signal through the readout line; and a connection portion electrically connecting the readout line to the readout circuit. The display area includes the sensing area including the sub-pixel and the optical sensor, and a non-sensing area including the sub-pixel. A connection line connecting the readout line and the connection portion to each other may be located in the non-sensing area.

According to one or more embodiments of the present disclosure, a display device having a minimized or reduced dead space may be provided by connecting a readout line and a connection portion to each other through a connection line disposed in a non-sensing area.

However, the aspects and features of the present disclosure are not limited to those described above. Additional aspects and features will be set forth, in part, in the detailed description that follows with reference to the figures, and in part, may be apparent therefrom, or may be learned by practicing one or more of the presented embodiments of the present disclosure.

### BRIEF DESCRIPTION OF DRAWINGS

The above and other aspects and features of the present disclosure will be more clearly understood from the following detailed description of the illustrative, non-limiting embodiments with reference to the accompanying drawings.
FIG. 1 illustrates a block diagram of a display device according to one or more embodiments of the present disclosure.
FIG. 2 illustrates a circuit diagram of an example of a sub-pixel of the display device of FIG. 1.
FIG. 3 illustrates a circuit diagram of an example of an optical sensor of the display device of FIG. 1.
FIG. 4 illustrates an example of a sensing area and a non-sensing area of the display device of FIG. 1.
FIG. 5 illustrates an example of a first display area and a second display area of the display device of FIG. 1.
FIG. 6 illustrates an example of a readout line disposed in a first display area of the display device of FIG. 1.
FIG. 7 illustrates an example of a readout line disposed in a second display area of the display device of FIG. 1.
FIG. 8-FIG. 23 illustrate layout views of an example of a sensing area of the display device of FIG. 1.
FIG. 24-FIG. 39 illustrate layout views of an example of a non-sensing area of the display device of FIG. 1.
FIG. 40 illustrates an example of a readout line disposed in a second display area of a display device according to one or more embodiments of the present disclosure.
FIG. 41 illustrates an example of a sensing area and a non-sensing area of a display device according to one or more embodiments of the present disclosure.
FIG. 42 illustrates an example of a first display area and a second display area of the display device of FIG. 41.
FIG. 43 illustrates an example of a readout line disposed in a first display area of the display device of FIG. 41.
FIG. 44 illustrates an example of a readout line disposed in a second display area of the display device of FIG. 41.
FIG. 45 illustrates an example of a sensing area and a non-sensing area of a display device according to one or more embodiments of the present disclosure.
FIG. 46 illustrates an example of a first display area and a second display area of the display device of FIG. 45.
FIG. 47 illustrates an example of a readout line disposed in a first display area of the display device of FIG. 45.
FIG. 48 illustrates an example of a readout line disposed in a second display area of the display device of FIG. 45.
FIG. 49 illustrates an example of a sensing area and a non-sensing area of a display device according to one or more embodiments of the present disclosure.
FIG. 50 illustrates an example of a first display area and a second display area of the display device of FIG. 49.
FIG. 51 illustrates an example of a readout line disposed in a first display area of the display device of FIG. 49.
FIG. 52 illustrates an example of a readout line disposed in a second display area of the display device of FIG. 49.
FIG. 53 illustrates a layout view of a first conductive layer, a first active layer, and a second conductive layer of a display device according to one or more embodiments of the present disclosure.
FIG. 54 illustrates a layout view of a third conductive layer of a display device according to one or more embodiments of the present disclosure.
FIG. 55 illustrates a layout view of a sixth conductive layer of a display device according to one or more embodiments of the present disclosure.
FIG. 56 illustrates a layout view of a seventh conductive layer of the display device of FIG. 55.
FIG. 57 illustrates a layout view of a sixth conductive layer of a display device according to embodiments of the present disclosure.
FIG. 58 illustrates a layout view of a seventh conductive layer of the display device of FIG. 57.
FIG. 59 illustrates a layout view of a sixth conductive layer of a display device according to one or more embodiments of the present disclosure.
FIG. 60 illustrates a block diagram of an electronic device according to one or more embodiments of the present disclosure.
FIG. 61 illustrates an example in which the electronic device of FIG. 60 is implemented as a smart phone.
FIG. 62 illustrates an example in which the electronic device of FIG. 60 is implemented as a tablet PC.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.
It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

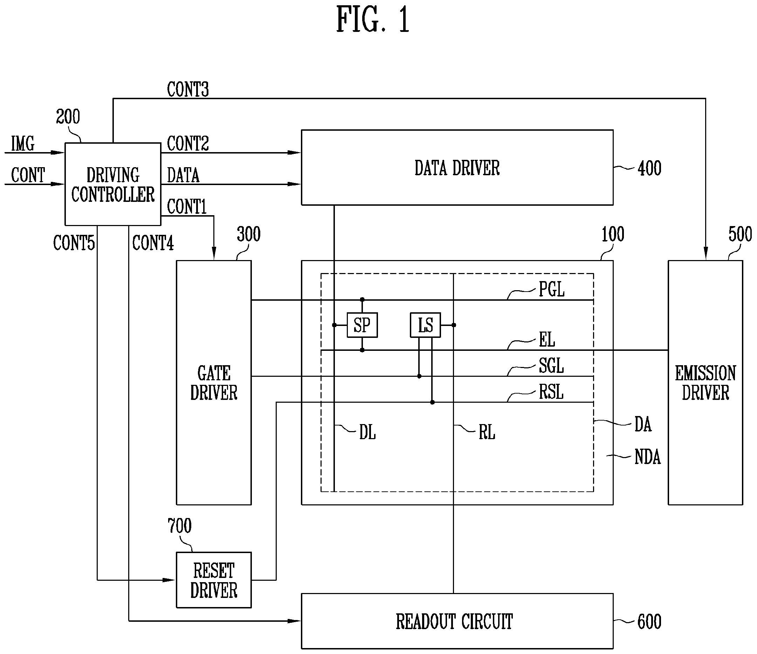

FIG. 1 illustrates a block diagram of a display device according to one or more embodiments of the present disclosure.

In FIG. 1, for convenience of illustration, a connection line and a connection portion described in more detail below are not shown.

Referring to FIG. 1, the display device may include a display panel 100 and a display panel driver. The display panel driver may include a driving controller 200, a gate driver 300, a data driver 400, an emission driver 500, a readout circuit 600, and a reset driver 700. In an embodiment, the driving controller 200 and the data driver 400 may be integrated together on a single chip. In an embodiment, the driving controller 200, the data driver 400, and the readout circuit 600 may be integrated together into one chip.

The display panel 100 may include a display area DA for displaying an image, and a non-display area NDA disposed adjacent to the display area DA. In an embodiment, the gate driver 300 and the emission driver 500 may be mounted in the non-display area NDA.

The display panel 100 may include a plurality of pixel gate lines PGL, a plurality of data lines DL, a plurality of emission lines EL, and a plurality of sub-pixels SP electrically connected to the pixel gate lines PGL, the data lines DL, and the emission lines EL. The pixel gate lines PGL and the emission lines EL may extend in a direction crossing the data lines DL.

The display panel 100 may include a plurality of sensing gate lines SGL, a reset line RSL, a plurality of readout lines RL, and a plurality of optical sensors LS electrically connected to the sensing gate lines SGL, the reset line RSL, and the read-out lines RL.

In the present embodiment, the sensing gate lines SGL are illustrated as being connected to the gate driver 300 in FIG. 1, but the present disclosure is not limited thereto. For example, the display panel driver may further include a separate driver that drives the sensing gate lines SGL.

In the present embodiment, the reset lines RSL are illustrated as being connected to the reset driver 700 in FIG. 1, but the present disclosure is not limited thereto. For example, the reset lines RSL may be driven by a separate driver that drives the gate driver 300, the emission driver 500, or the sensing gate lines SGL, rather than the reset driver 700.

The driving controller 200 may receive input image data IMG and an input control signal CONT from a processor (e.g., a graphics processing unit (GPU) and/or the like). For example, the input image data IMG may include red image data, green image data, and blue image data. In an embodiment, the input image data IMG may further include white image data. For another example, the input image data IMG may include magenta image data, yellow image data, and cyan image data. The input control signal CONT may include a master clock signal and a data enable signal. The input control signal CONT may further include a vertical synchronization signal and a horizontal synchronization signal.

The driving controller 200 may generate a first control signal CONT1, a second control signal CONT2, a third control signal CONT3, a fourth control signal CONT4, a fifth control signal CONT5, and a data signal DATA based on the input image data IMG and the input control signal CONT.

The driving controller 200 may generate the first control signal CONT1 for controlling the operation of the gate driver 300 based on the input control signal CONT, and may output the first control signal CONT1 to the gate driver 300. The first control signal CONT1 may include a vertical start signal and a gate clock signal.

The driving controller 200 may generate the second control signal CONT2 for controlling the operation of the data driver 400 based on the input control signal CONT, and may output the second control signal CONT2 to the data driver 400. The second control signal CONT2 may include a horizontal start signal and a load signal.

The driving controller 200 may receive the input image data IMG and the input control signal CONT to generate the data signal DATA. The driving controller 200 may output the data signal DATA to the data driver 400.

The driving controller 200 may generate the third control signal CONT3 for controlling the operation of the emission driver 500 based on the input control signal CONT, and may output the third control signal CONT3 to the emission driver 500. The third control signal CONT3 may include a vertical start signal and an emission clock signal.

The driving controller 200 may generate the fourth control signal CONT4 for controlling the operation of the readout circuit 600 based on the input control signal CONT, and may output the fourth control signal CONT4 to the readout circuit 600.

The driving controller 200 may generate the fifth control signal CONT5 for controlling the operation of the reset driver 700 based on the input control signal CONT, and may output the fifth control signal CONT5 to the reset driver 700.

The gate driver 300 may generate gate signals for driving the pixel gate lines PGL and the sensing gate lines SGL in response to the first control signal CONT1 received from the driving controller 200. The gate driver 300 may output the gate signals to the pixel gate lines PGL and the sensing gate lines SGL. For example, the gate driver 300 may sequentially output the gate signals to the pixel gate lines PGL and the sensing gate lines SGL.

The data driver 400 may receive the second control signal CONT2 and the data signal DATA from the driving controller 200. The data driver 400 may generate data voltages obtained by converting the data signal DATA into an analog voltage. The data driver 400 may output the data voltages to the data lines DL.

The emission driver 500 may generate emission signals for driving the emission lines EL in response to the third control signal CONT3 received from the driving controller 200. The emission driver 500 may output the emission signals to the emission lines EL. For example, the emission driver 500 may sequentially output the emission signals to the emission lines EL.

The readout circuit 600 may generate sensing information based on the sensing signals received from the readout lines RL in response to the fourth control signal CONT4 received from the driving controller 200. For example, the sensing information may correspond to a fingerprint image. The processor or the driving controller 200 may perform a user authentication function using the sensing information provided from the readout circuit 600.

The reset driver 700 may provide a reset signal to the reset lines RSL in response to the fifth control signal CONT5 received from the driving controller 200. In an embodiment, the reset driver 700 may be commonly connected to all optical sensors LS through the reset line RSL. In another embodiment, the reset driver 700 may be connected to each of the optical sensors LS through a plurality of reset lines RSL.

The sub-pixel SP may include a light emitting element. The light emitting element may be a light emitting diode. The light emitting element may include an organic light emitting diode, an inorganic light emitting diode, and/or a quantum dot/well light emitting diode. The light emitting element may emit light in one of a first color, a second color, and/or a third color.

The optical sensor LS may include a light receiving element. In an embodiment, the light receiving element may be a photo diode. In another embodiment, the light receiving element may be configured of a photo transistor.

The light emitted from the light emitting element may be reflected by the user's fingerprint to be applied to the light receiving element adjacent to the light emitting element. In addition, the optical sensor LS may generate a sensing signal corresponding to the amount of light applied to the light receiving element. The processor or driving controller 200 may distinguish valleys and ridges of the fingerprint according to the strength of the sensing signal, and may obtain an image of the user's fingerprint.

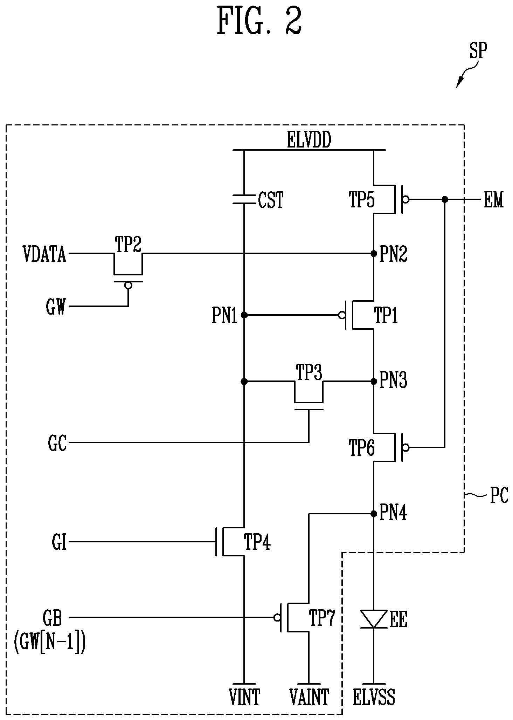

FIG. 2 illustrates a circuit diagram of an example of a sub-pixel of the display device of FIG. 1.

Referring to FIG. 2, the sub-pixel SP may include a light emitting element EE, and a pixel driving circuit PC that drives the light emitting element EE.

The pixel driving circuit PC may include a first pixel transistor TP1 (e.g., a driving transistor) including a control electrode connected to a first pixel node PN1, a first electrode connected to a second pixel node PN2, and a second electrode connected to a third pixel node PN3. The pixel driving circuit PC may further include a second pixel transistor TP2 including a control electrode that receives a write gate signal GW, a first electrode that receives a data voltage VDATA, and a second electrode connected to the second pixel node PN2. The pixel driving circuit PC may further include a third pixel transistor TP3 including a control electrode that receives a compensation gate signal GC, a first electrode connected to the third pixel node PN3, and a second electrode connected to the first pixel node PN1. The pixel driving circuit PC may further include a fourth pixel transistor TP4 including a control electrode that receives a initialization gate signal GI, a first electrode that receives a first initialization voltage VINT, and a second electrode connected to the first pixel node PN1. The pixel driving circuit PC may further include a fifth pixel transistor TP5 including a control electrode that receives an emission signal EM, a first electrode that receives a first power supply voltage ELVDD (e.g., a high power supply voltage), and a second electrode connected to the second pixel node PN2. The pixel driving circuit PC may further include a sixth pixel transistor TP6 including a control electrode that receives the emission signal EM, a first electrode connected to the third pixel node PN3, and a second electrode connected to a fourth pixel node PN4. The pixel driving circuit PC may further include a seventh pixel transistor TP7 including a control electrode that receives a bias gate signal GB (or a write gate signal GW(N-1) of a previous pixel row), a first electrode that receives a second initialization voltage VAINT (e.g., an anode initialization voltage), and a second electrode connected to the fourth pixel node PN4. The pixel driving circuit PC may further include a storage capacitor CST including a first electrode that receives the first power supply voltage ELVDD, and a second electrode connected to the first pixel node PN1. The light emitting element EE may include a first electrode (e.g., an anode electrode) connected to the fourth pixel node PN4, and a second electrode (e.g., a cathode electrode) for receiving a second power supply voltage ELVSS (e.g., a low power supply voltage).

However, the present disclosure is not limited to the structure of the sub-pixel SP shown in FIG. 2. For example, each of the sub-pixels SP may have a 3T1C structure with three transistors and one capacitor, a 5T2C structure with five transistors and two capacitors, a 7T1C structure with seven transistors and one capacitor, and/or a 9T1C structure with nine transistors and one capacitor.

The first, second, and fifth to seventh pixel transistors TP1, TP2, TP5, TP6, and TP7 may be implemented as p-channel metal oxide semiconductor (PMOS) transistors. In this case, a low voltage level may be an activation level, and a high voltage level may be an inactivation level. For example, when a signal applied to the control electrode of the PMOS transistor has the low voltage level, the PMOS transistor may be turned on. For example, when a signal applied to the control electrode of the PMOS transistor has the high voltage level, the PMOS transistor may be turned off.

The third and fourth pixel transistors TP3 and TP4 may be implemented as n-channel metal oxide semiconductor (NMOS) transistors. In this case, a high voltage level may be an activation level, and a low voltage level may be an inactivation level. For example, when a signal applied to the control electrode of the NMOS transistor has the high voltage level, the NMOS transistor may be turned on. For example, when a signal applied to the control electrode of the NMOS transistor has the low voltage level, the NMOS transistor may be turned off.

However, the present disclosure is not limited thereto. For example, the first, second, and fifth to seventh transistors TP1, TP2, TP5, TP6, and TP7 may be implemented as NMOS transistors. For example, the third and fourth pixel transistors TP3 and TP4 may be implemented as PMOS transistors.

For example, in an initialization period, the initialization gate signal Gl may have an activation level, and the fourth pixel transistor TP4 may be turned on. Accordingly, the first initialization voltage VINT may be applied to the first pixel node PN1. In other words, the control electrode (e.g., the storage capacitor CST) of the first pixel transistor TP1 may be initialized.

For example, in a data write period, the write gate signal GW and the compensation gate signal GC may have an activation level, and the second pixel transistor TP2 and the third pixel transistor TP3 may be turned on. Accordingly, the data voltage VDATA may be written to the storage capacitor CST.

For example, in an anode initialization period, the bias gate signal GB may have an activation level, and the seventh pixel transistor TP7 may be turned on. Accordingly, the second initialization voltage VAINT may be applied to the first electrode (e.g., the anode electrode) of the light emitting element EE.

For example, in a light emitting period, the emission signal EM may have an activation level, and the fifth pixel transistor TP5 and the sixth pixel transistor TP6 may be turned on. Accordingly, the first power supply voltage ELVDD is applied to the first pixel transistor TP1 to generate a driving current, and the driving current may be applied to the light emitting element EE. In other words, the light emitting element EE may emit light having a luminance corresponding to the driving current.

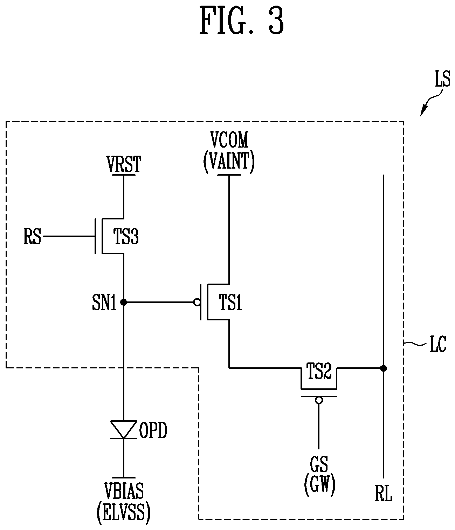

FIG. 3 illustrates a circuit diagram of an example of an optical sensor of the display device of FIG. 1.

Referring to FIG. 3, the optical sensor LS may include a light receiving element OPD, and a sensor driving circuit LC that drives the light receiving element OPD.

The sensor driving circuit LC may include a first sensing transistor TS1 that generates a sensing signal, a second sensing transistor TS2 that provides the sensing signal to the readout line RL in response to a sensing gate signal GS, and a light receiving element OPD connected to a control node of the first sensing transistor TS1. The optical sensor LS may further include a third sensing transistor TS3 that initializes the control node of the first sensing transistor TS1 in response to a reset signal RS. For example, the sensing signal may be a current generated by the first sensing transistor TS1.

For example, the first sensing transistor TS1 includes a control electrode connected to a first sensing node SN1, a first electrode for receiving a common voltage VCOM, and a second electrode connected to a first electrode of the second sensing transistor TS2. The second sensing transistor TS2 includes a control electrode for receiving the sensing gate signal GS, a first electrode connected to the second electrode of the first sensing transistor TS1, and a second electrode connected to the readout line RL. The light receiving element OPD may include a first electrode connected to the first sensing node SN1 and a second electrode for receiving a bias voltage VBIAS. The third sensing transistor TS3 may include a control electrode for receiving the reset signal RS, a first electrode for receiving a reset voltage VRST, and a second electrode connected to the first sensing node SN1.

In an embodiment, the first and second sensing transistors TS1 and TS2 may be implemented as PMOS transistors, and the third sensing transistor TS3 may be implemented as an NMOS transistor. However, the present disclosure is not limited thereto.

For example, in a reset period, the reset signal RS may have an activation level, and the sensing gate signal GS may have an inactivation level. Accordingly, the third sensing transistor TS3 may be turned on, and the second sensing transistor TS2 may be turned off. In addition, the reset voltage VRST may be applied to the first sensing node SN1. In other words, the first sensing node SN1 and the first electrode of the light receiving element OPD may be initialized.

For example, in a light receiving period, the reset signal RS and the sensing gate signal GS may have an inactivation level. Accordingly, the second sensing transistor TS2 and the third sensing transistor TS3 may be turned off. In addition, when light is applied, the light receiving element OPD generates a current in the direction of the first sensing node SN1, and the voltage of the first sensing node SN1 may be lowered. Accordingly, a strength of the sensing signal generated in a sensing on period, which will be described in more detail below, may vary. In addition, because the amount of light applied to the light receiving element OPD varies depending on the valleys and ridges of the fingerprint, the intensity of the sensing signal may vary depending on the valleys and ridges of the fingerprint.

For example, in the sensing on period, the reset signal RS may have an inactivation level, and the sensing gate signal GS may have an activation level. Accordingly, the second sensing transistor TS2 may be turned on, and the third sensing transistor TS3 may be turned off. In addition, the first sensing transistor TS1 may generate a sensing signal corresponding to the gate-source voltage thereof. The sensing signal may be applied to the readout circuit through the readout line RL.

In an embodiment, the common voltage VCOM may be the second initialization voltage VAINT. In an embodiment, the bias voltage VBIAS may be the second power supply voltage ELVSS.

In an embodiment, the sensing gate signal GS may be the write gate signal GW. In this case, the pixel gate line PGL to which the write gate signal GW is applied may be the same as the sensing gate line SGL to which the sensing gate signal GS is applied.

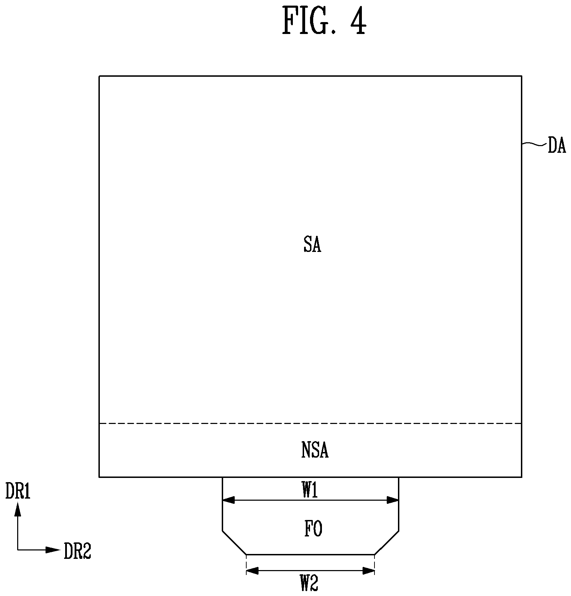

FIG. 4 illustrates an example of a sensing area and a non-sensing area of the display device of FIG. 1.

Referring to FIG. 1 to FIG. 4, the display area DA may include a sensing area SA including the sub-pixel SP and the optical sensor LS, and a non-sensing area NSA including the sub-pixel SP. For example, the display area DA may include the pixel driving circuit PC and the sensor driving circuit LC, while the non-sensing area NSA may include the pixel driving circuit PC and may not include the sensor driving circuit LC.

The non-sensing area NSA may be adjacent to a connection portion FO in the first direction DR1. The sensing area SA may be adjacent to the non-sensing area NSA in the first direction DR1. For example, the non-sensing area NSA may be formed between the sensing area SA and the connection portion FO.

The display device may include the connection portion FO that electrically connects the readout line RL to the readout circuit 600. The connection portion FO may electrically connect the readout line RL to the readout circuit 600, as well as the data line DL to the data driver 400.

In an embodiment, a width W1 of a first surface (e.g., a first end) of the connection portion FO adjacent to the display area DA may be longer than a width W2 of a second surface (e.g., a second end) thereof connected to the readout circuit 600 (or to the data driver 400). The width of the readout circuit 600 (or the data driver 400) may be narrow (e.g., very narrow) compared to that of the display area DA. Accordingly, the connection portion FO may allow the readout line RL (or the data line DL) of the display area DA to be properly connected to the readout circuit 600 (or to the data driver 400).

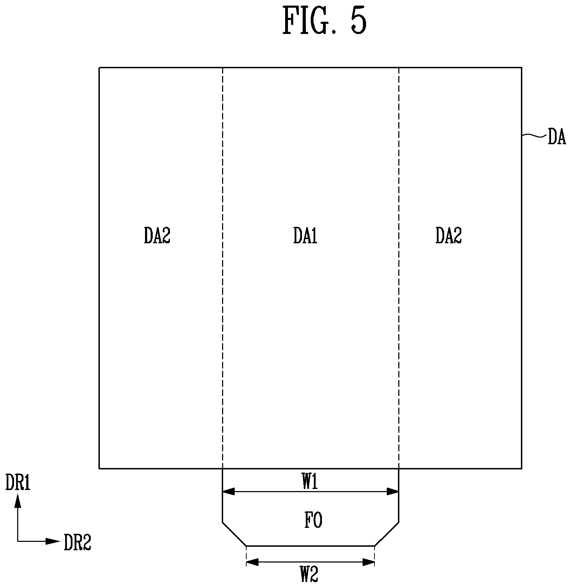

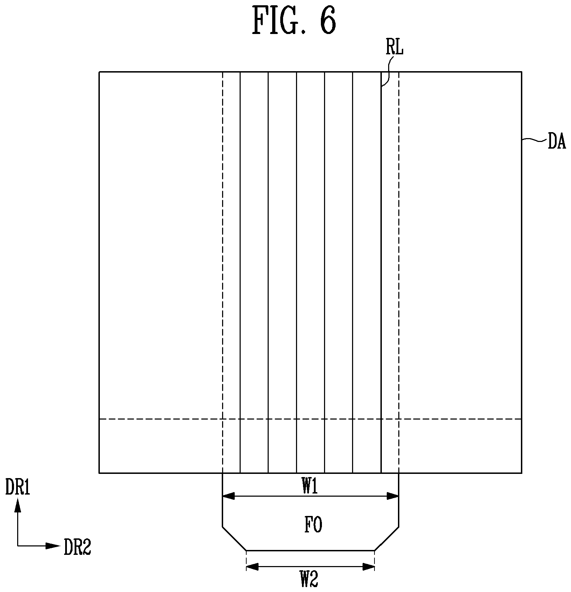

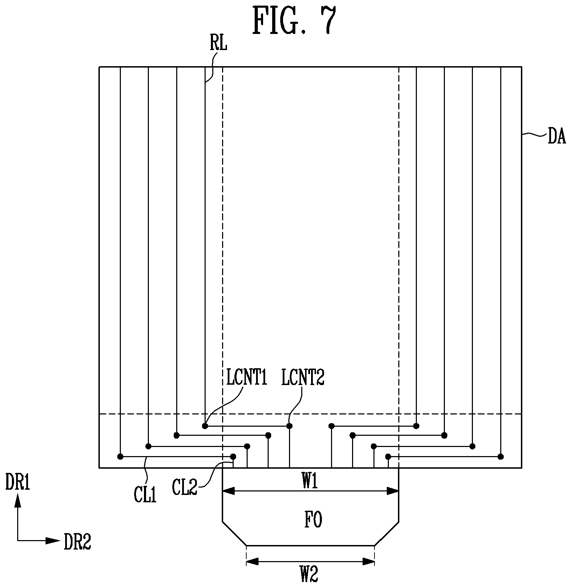

FIG. 5 illustrates an example of a first display area and a second display area of the display device of FIG. 1. FIG. 6 illustrates an example of a readout line disposed in a first display area of the display device of FIG. 1. FIG. 7 illustrates an example of a readout line disposed in a second display area of the display device of FIG. 1.

Referring to FIG. 1 to FIG. 7, the readout line RL extends in the first direction DR1. The display area DA includes a first display area DA1 adjacent to the connection portion FO in the first direction DR1, and a second display area DA2. Connection lines CL1 and CL2 may connect the readout line RL of the second display area DA2 to the connection portion FO.

The readout line RL of the first display area DA1 may extend in the first direction DR1 to be directly connected to the connection portion FO. However, the readout line RL of the second display area DA2 may employ an additional wire to be connected to the connection portion FO. Accordingly, the readout line RL of the second display area DA2 may be connected to the connection portion FO through the connection lines CL1 and CL2.

The connection lines CL1 and CL2 connecting the readout line RL and the connection portion FO to each other may be disposed in the non-sensing area NSA. When the connection lines CL1 and CL2 are disposed in the sensing area SA, coupling may occur between the connection lines CL1 and CL2 and the sensor driving circuit LC. In this case, the sensing signal may be distorted, and the accuracy of sensing by the optical sensor LS may decrease.

For example, the readout line RL extends in the first direction DR1. The connection lines CL1 and CL2 include a first connection line CL1 and a second connection line CL2. The first connection line CL1 may extend in a second direction DR2 crossing the first direction DR1, and may be connected to the readout line RL through a first line contact hole LCNT1. The second connection line CL2 may extend in the first direction DR1, and may be connected to the first connection line CL1 through a second line contact hole LCNT2. For example, the second connection line CL2 may be connected to the connection portion FO.

In an embodiment, the readout line RL, the first connection line CL1, and the second connection line CL2 may be formed in different layers from each other. In an embodiment, the first and second line contact holes LCNT1 and LCNT2 may be channel contact holes and/or via contact holes. For example, when an organic film is disposed between the readout line RL and the first connection line CL1, the first line contact hole LCNT1 may be a channel contact hole. As another example, when an inorganic film is disposed between the readout line RL and the first connection line CL1, the first line contact hole LCNT1 may be a via contact hole. As another example, when an organic film and an inorganic film are disposed between the read-out line RL and the first connection line CL1, the first line contact hole LCNT1 may include both a channel contact hole and a via contact hole. For example, when an organic film is disposed between the first connection line CL1 and the second connection line CL2, the first line contact hole LCNT1 may be a channel contact hole. As another example, when an inorganic film is disposed between the first connection line CL1 and the second connection line CL2, the first line contact hole LCNT1 may be a via contact hole. As another example, when an organic film and an inorganic film are disposed between the first connection line CL1 and the second connection line CL2, the first line contact hole LCNT1 may include both a channel contact hole and a via contact hole.

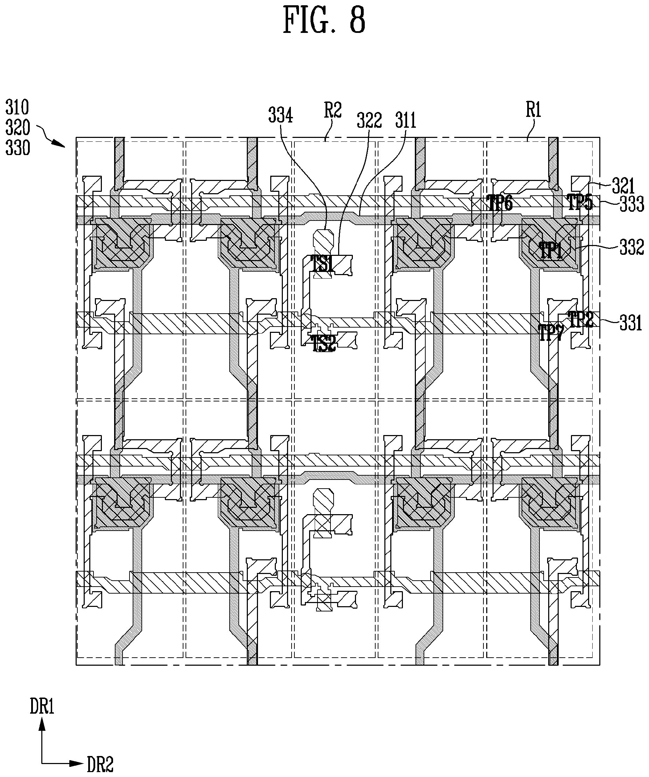

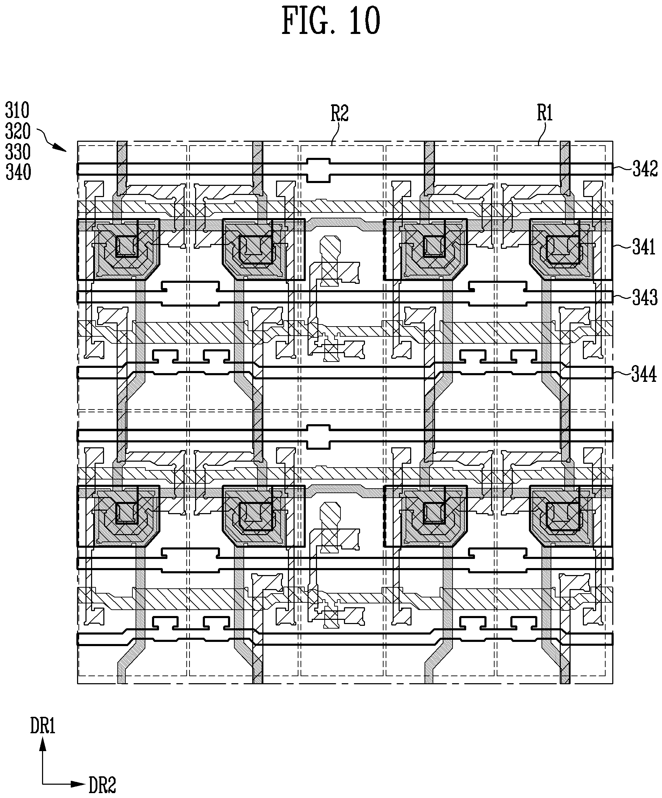

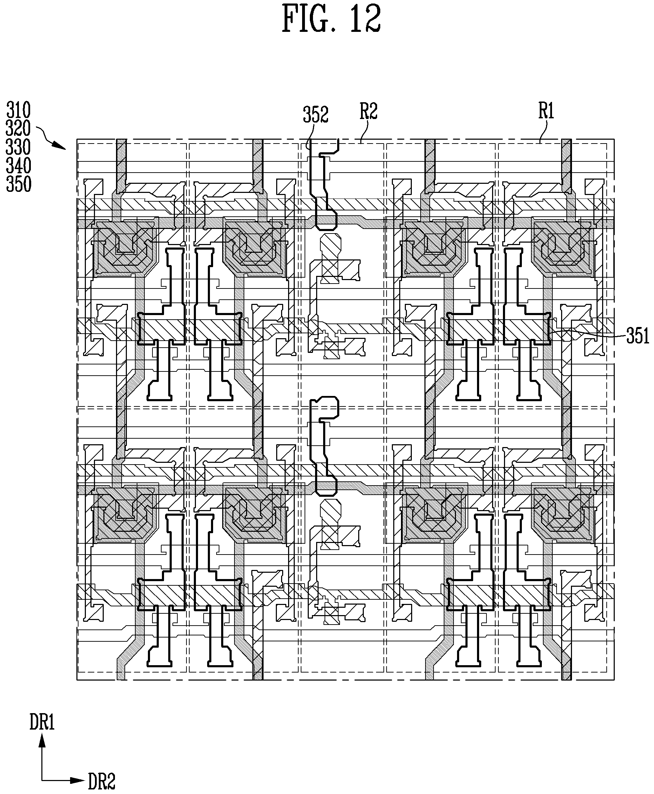

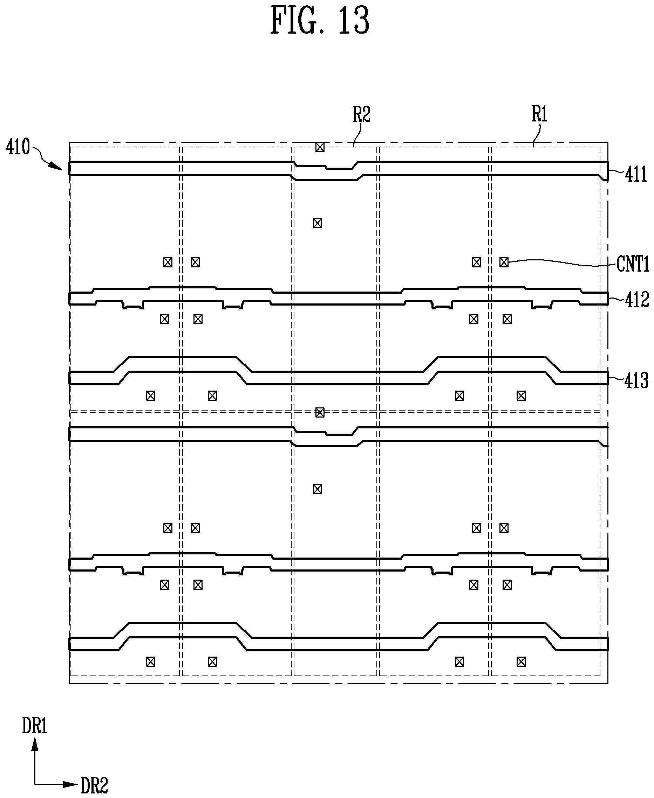

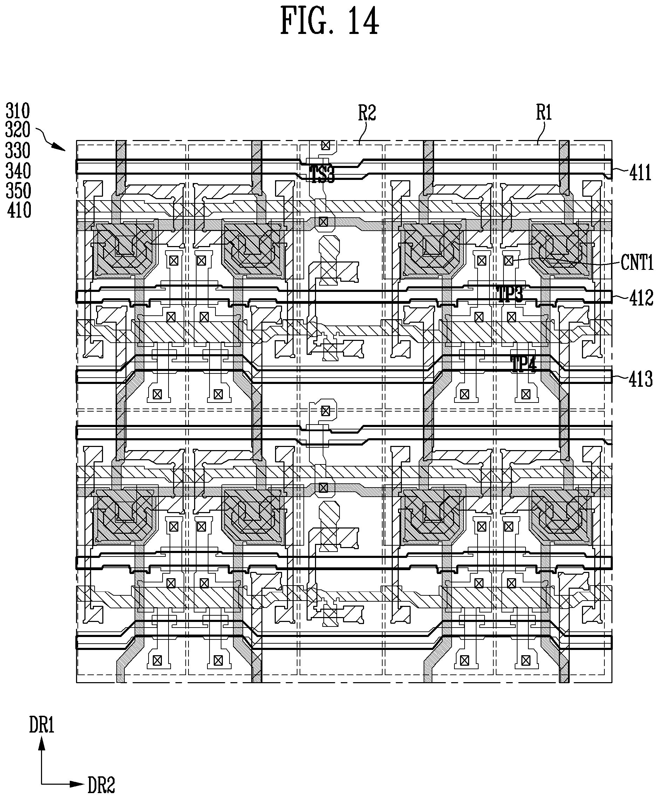

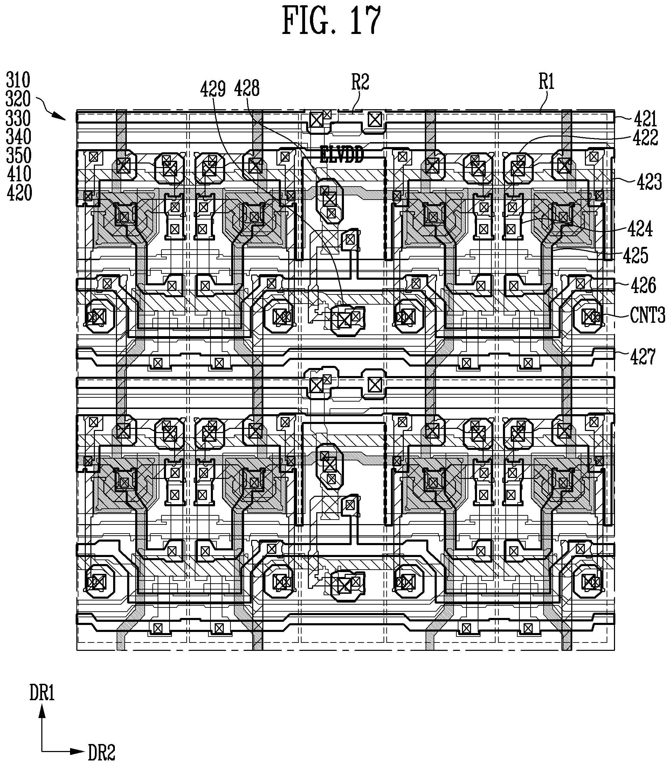

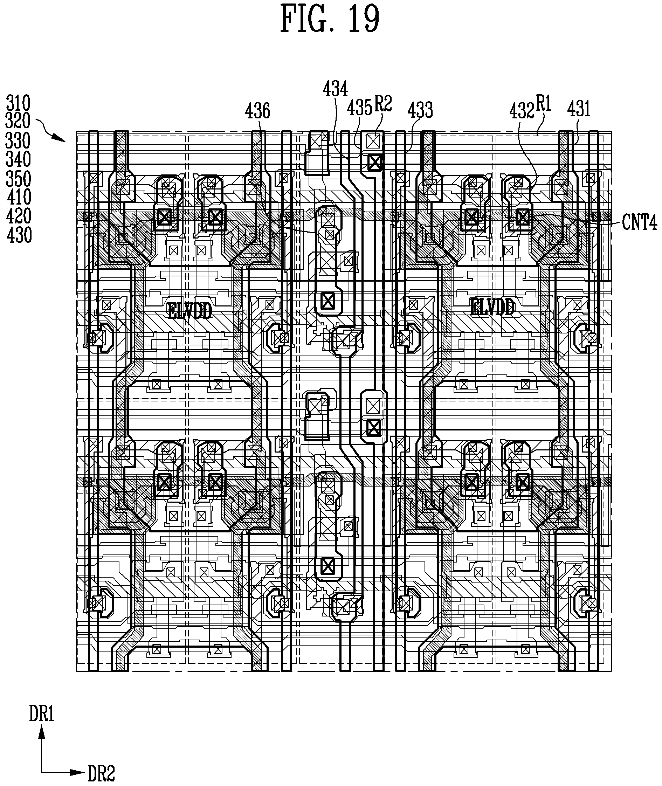

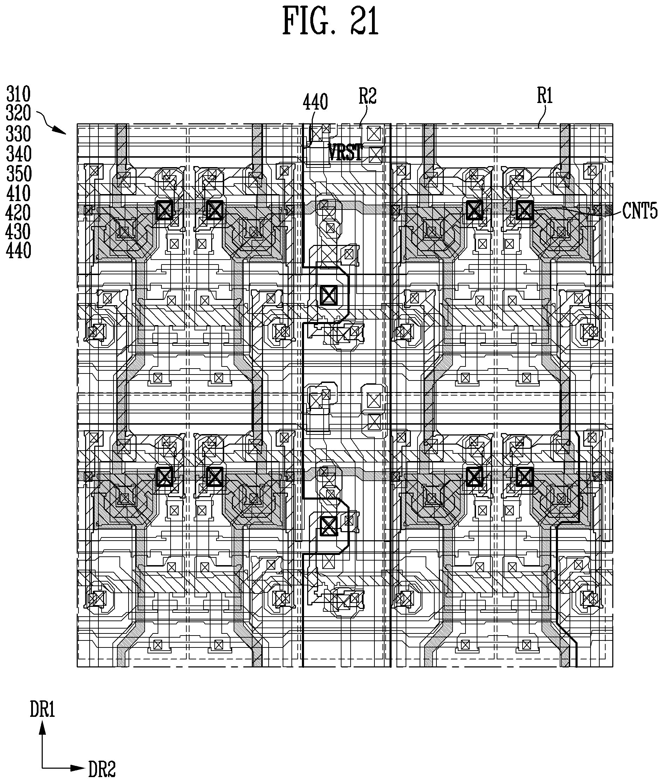

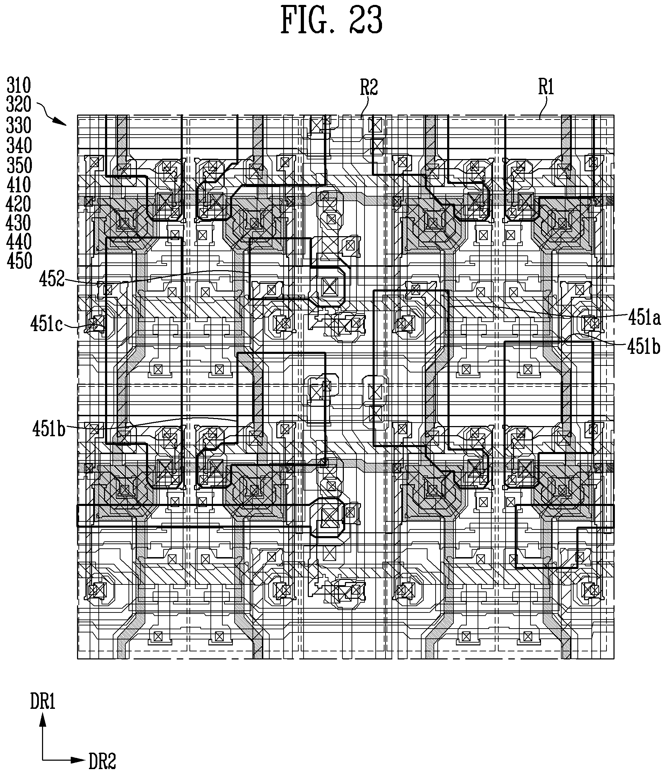

FIG. 8 through FIG. 23 illustrate layout views of an example of a sensing area of the display device of FIG. 1.

Referring to FIG. 2 to FIG. 4 and FIG. 8, the sensing area SA may include a first area R1 including the pixel driving circuit PC, and a second area R2 adjacent to the first area R1, and including the sensor driving circuit LC. The display device may include a first conductive layer 310, a first active layer 320, and a second conductive layer 330.

The first conductive layer 310 and the second conductive layer 330 may include a metal, an alloy, a conductive metal oxide, a transparent conductive material, and/or the like. These may be used alone or in any suitable combination with each other.

The first active layer 320 may include a metal oxide semiconductor (e.g., indium gallium zinc oxide (IGZO)), an inorganic semiconductor (e.g., amorphous silicon), poly silicon, or an organic semiconductor.

The first conductive layer 310 may include a (1-1)-th conductive pattern 311. A portion of the (1-1)-th conductive pattern 311 may form the back gate electrode of the first pixel transistor TP1.

The first active layer 320 may be disposed on the first conductive layer 310. The first active layer 320 may include a (1-1)-th active pattern 321 and a (1-2)-th active pattern 322. The second conductive layer 330 may be disposed on the first active layer 320. The second conductive layer 330 may include a (2-1)-th conductive pattern 331, a (2-2)-th conductive pattern 332, and a (2-3)-th conductive pattern 333.

The (1-1)-th active pattern 321 and a portion (e.g., a control electrode) of the (2-1)-th conductive pattern 331 overlapping with the (1-1)-th active pattern 321 may configure the second pixel transistor TP2, the seventh pixel transistor TP7, and the second sensing transistor TS2. For example, the (2-1)-th conductive pattern 331 may be the pixel gate line PGL to which the write gate signal (GW) is applied.

The (1-1)-th active pattern 321 and a portion (e.g., a control electrode) of the (2-2)-th conductive pattern 332 that overlaps with the (1-1)-th active pattern 321 may configure the first pixel transistor TP1.

The (1-1)-th active pattern 321 and a portion (e.g., a control electrode) of the (2-3)-th conductive pattern 333 that overlaps with the (1-1)-th active pattern 321 may configure the fifth pixel transistor TP5 and the sixth pixel transistor TP6. For example, the (2-3)-th conductive pattern 333 may be the emission line EL to which the emission signal EM is applied.

The (1-2)-th active pattern 322 and a portion (e.g., a control electrode) of the (2-4)-th conductive pattern 334 that overlaps with the (1-2)-th active pattern 322 may configure the first sensing transistor TS1.

The (1-2)-th active pattern 323 and a portion (e.g., a control electrode) of the (2-1)-th conductive pattern 334 that overlaps with the (1-3)-th active pattern 323 may configure the second sensing transistor TS2.

Referring to FIG. 2 to FIG. 4 and FIG. 8 to FIG. 10, the display device may include a third conductive layer 340.

The third conductive layer 340 may include a metal, an alloy, a conductive metal oxide, a transparent conductive material, and/or the like. These may be used alone or in any suitable combination with each other.

The third conductive layer 340 may be disposed on the second conductive layer 330. The third conductive layer 340 may include a (3-1)-th conductive pattern 341, a (3-2)-th conductive pattern 342, a (3-3)-th conductive pattern 343, and a (3-4)-th conductive pattern 344.

The (3-1)-th conductive pattern 341 and the (2-2)-th conductive pattern 332 may configure the storage capacitor CST. The (3-2)-th conductive pattern 342 may be the reset line RSL to which the reset signal RS is applied. The (3-3)-th conductive pattern 343 may be the pixel gate line PGL to which the compensation gate signal GC is applied. The (3-4)-th conductive pattern 344 may be the pixel gate line PGL to which the initialization gate signal Gl is applied.

Referring to FIG. 2 to FIG. 4 and FIG. 8 to FIG. 12, the display device may include a second active layer 350.

The second active layer 350 may include a metal oxide semiconductor (e.g., indium gallium zinc oxide), an inorganic semiconductor (e.g., amorphous silicon or poly silicon), or an organic semiconductor.

The second active layer 350 may be disposed on the third conductive layer 340. The second active layer 350 may include a (2-1)-th active pattern 351 and a (2-2)-th active pattern 352.

Referring to FIG. 2 to FIG. 4 and FIG. 8 to FIG. 14, the display device may include a fourth conductive layer 410.

The fourth conductive layer 410 may include a metal, an alloy, a conductive metal oxide, a transparent conductive material, and/or the like. These may be used alone or in any suitable combination with each other.

The fourth conductive layer 410 may be disposed on the second active layer 350. The fourth conductive layer 410 may include a (4-1)-th conductive pattern 411, a (4-2)-th conductive pattern 412, and a (4-3)-th conductive pattern 413.

The (4-1)-th conductive pattern 411 and the (3-2)-th conductive pattern 342 may be connected to each other through a channel contact hole and/or a via contact hole in the display area DA or the non-display area NDA. The (4-2)-th conductive pattern 412 and the (3-3)-th conductive pattern 343 may be connected to each other through a channel contact hole and/or a via contact hole in the display area DA or the non-display area NDA. The (4-3)-th conductive pattern 413 and the (3-4)-th conductive pattern 344 may be connected to each other through a channel contact hole and/or a via contact hole in the display area DA or the non-display area NDA.

The (4-1)-th conductive pattern 411 may be the reset line RSL to which the reset signal RS is applied. The (4-2)-th conductive pattern 412 may be the pixel gate line PGL to which the compensation gate signal GC is applied. The (4-3)-th conductive pattern 413 may be the pixel gate line PGL to which the initialization gate signal Gl is applied.

The (2-1)-th active pattern 351 and a portion of the (4-2)-th conductive pattern 412 (or a portion of the (3-3)-th conductive pattern 343) (e.g.,, a control electrode) overlapping with the (2-1)-th active pattern 351 may configure the third pixel transistor TP3.

The (2-1)-th active pattern 351 and a portion of the (4-3)-th conductive pattern 413 (or a portion of the (3-4)-th conductive pattern 344) (e.g., a control electrode) overlapping with the (2-1)-th active pattern 351 may configure the fourth pixel transistor TP4.

The (2-2)-th active pattern 352 and a portion of the (4-1)-th conductive pattern 411 (or a portion of the (3-2)-th conductive pattern 342) (e.g., a control electrode) overlapping with the (3-2)-th active pattern 352 may configure the third sensing transistor TS3.

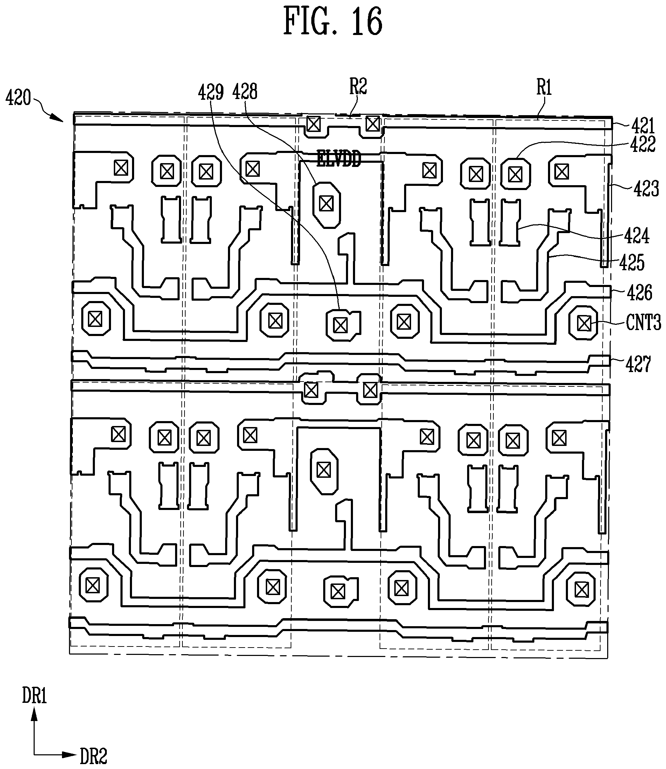

The display device may include a first contact hole CNT1. The first contact hole CNT1 may connect the second active layer 350 to a fifth conductive layer (e.g., 420 in FIG. 16), which will be described in more detail below. For example, the first contact hole CNT1 may be a channel contact hole and/or a via contact hole. For example, the first contact hole CNT1 may connect the second active layer 350 to the fifth conductive layer (e.g., 420 in FIG. 16), which will be described in more detail below.

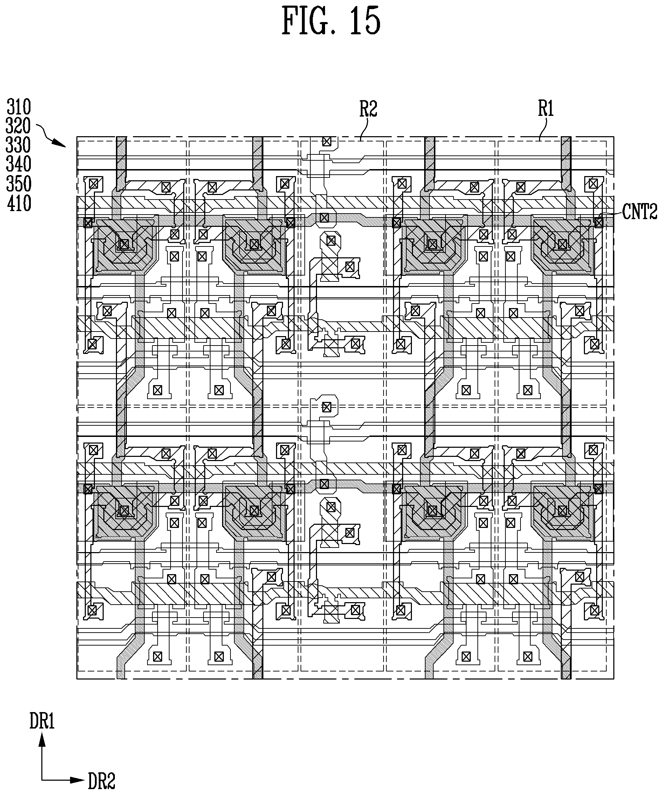

Referring to FIG. 15, the display device may include a second contact hole CNT2. The second contact hole CNT2 may connect the first active layer 320, the second conductive layer 330, and the third conductive layer 340 to the fifth conductive layer 420, which will be described in more detail below. For example, the second contact hole CNT2 may be a channel contact hole and/or a via contact hole.

Referring to FIG. 2 to FIG. 4 and FIG. 8 to FIG. 17, the display device may include the fifth conductive layer 420.

The fifth conductive layer 420 may include a metal, an alloy, a conductive metal oxide, a transparent conductive material, and/or the like. These may be used alone or in any suitable combination with each other.

The fifth conductive layer 420 may be disposed the fourth conductive layer 410. The fifth conductive layer 420 may include a (5-1)-th conductive pattern 421, a (5-2)-th conductive pattern 422, a (5-3)-th conductive pattern 423, a (5-4)-th conductive pattern 424, a (5-5)-th conductive pattern 425, a (5-6)-th conductive pattern 426, a (5-7)-th conductive pattern 427, a (5-8)-th conductive pattern 428, and a (5-9)-th conductive pattern 429.

The (5-1)-th conductive pattern 421 may be the reset voltage line to which the reset voltage VRST is applied. The (5-6)-th conductive pattern 426 may be the anode initialization voltage line to which the second initialization voltage VAINT is applied. The (5-7)-th conductive pattern 427 may be the gate initialization voltage line to which the first initialization voltage VINT is applied.

The (5-2)-th conductive pattern 422 may configure the second electrode of the sixth pixel transistor TP6 or the first electrode of the light emitting element EE. The (5-3)-th conductive pattern 423 may configure the first electrode of the fifth pixel transistor TP5. The (5-4)-th conductive pattern 424 may configure the first electrode of the third pixel transistor TP3, the second electrode of the first pixel transistor TP1, or the first electrode of the sixth pixel transistor TP6. The (5-5)-th conductive pattern 425 may configure the first electrode of the storage capacitor CST, the control electrode of the first pixel transistor TP1, or the second electrode of the fourth pixel transistor TP4. The (5-8)-th conductive pattern 428 may configure the second electrode of the third sensing transistor TS3 or the first electrode of the light receiving element OPD. The (5-9)-th conductive pattern 429 may form the second electrode of the second sensing transistor TS2 or the readout line RL.

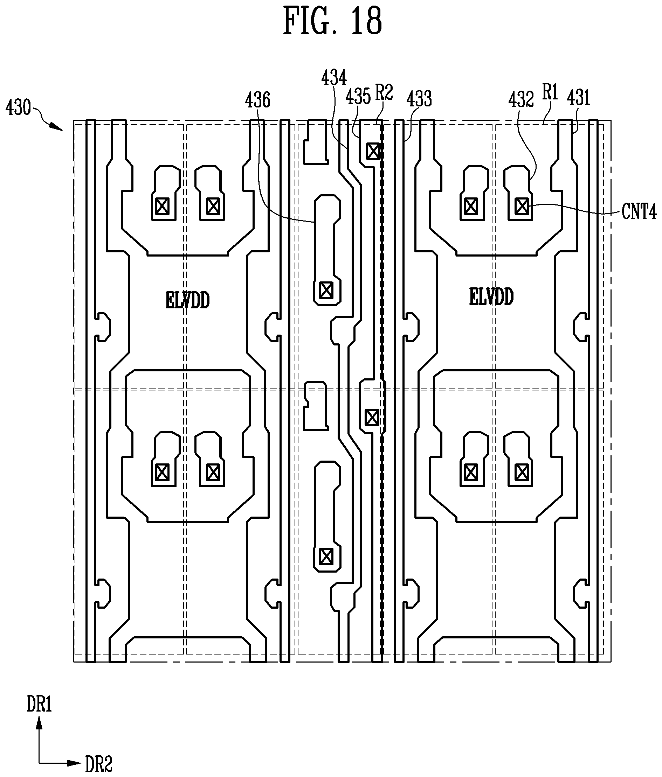

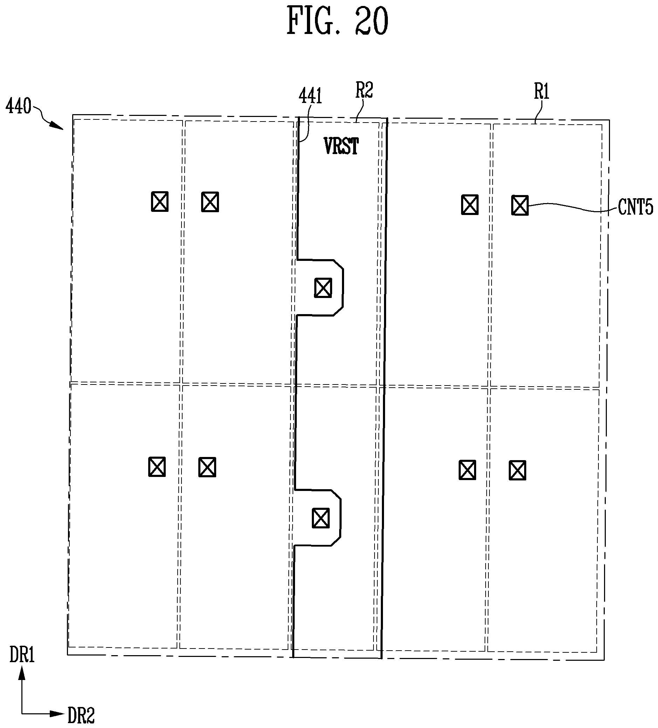

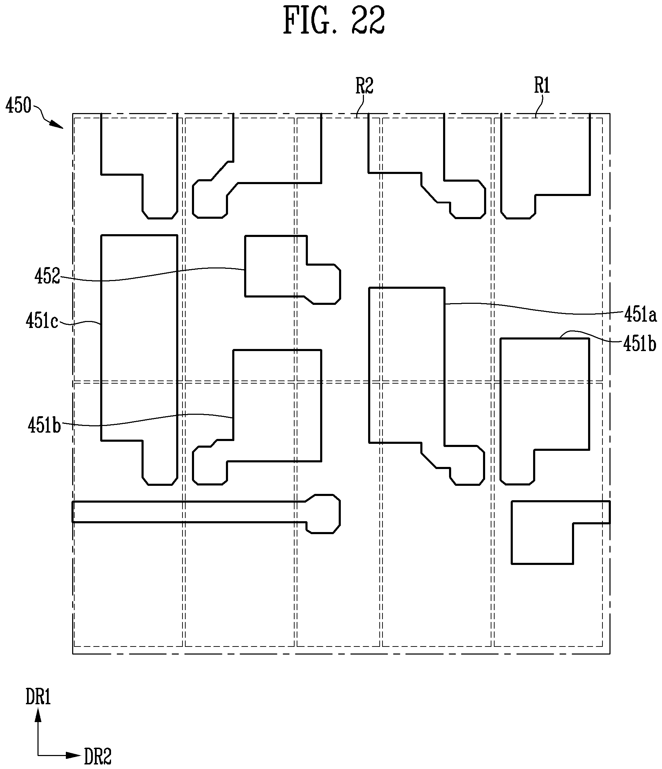

The display device may include a third contact hole CNT3. The third contact hole CNT3 may connect the fifth conductive layer 420 to a sixth conductive layer (e.g., 430 in FIG. 18), a seventh conductive layer (e.g., 440 in FIG. 20), or an eighth conductive layer (e.g., 450 in FIG. 22), which will be described in more detail below. When the third contact hole CNT3 connects the fifth conductive layer 420 to the seventh conductive layer (e.g., 440 in FIG. 20) or the eighth conductive layer 450, the third contact hole CNT3 may be connected to a fourth contact hole CNT4, which will be described in more detail below. For example, the third contact hole CNT3 may be a channel contact hole and/or a via contact hole.

Referring to FIG. 2 to FIG. 4 and FIG. 8 to FIG. 19, the display device may include a sixth conductive layer 430.

The sixth conductive layer 430 may include a metal, an alloy, a conductive metal oxide, a transparent conductive material, and/or the like. These may be used alone or in any suitable combination with each other.

The sixth conductive layer 430 may be disposed on the fifth conductive layer 420. The sixth conductive layer 430 may include a (6-1)-th conductive pattern 431, a (6-2)-th conductive pattern 432, a (6-3)-th conductive pattern 433, a (6-4)-th conductive pattern 434, a (6-5)-th conductive pattern 435, and (6-6)-th conductive pattern 436.

The (6-1)-th conductive pattern 431 may be the first power supply voltage line to which the first power supply voltage ELVDD is applied. The (6-1)-th conductive pattern 433 may be the data line DL to which the data voltage VDATA is applied. The (6-4)-th conductive pattern 434 may be the readout line RL to which the sensing signal is applied. The (6-5)-th conductive pattern 435 may be the reset voltage line to which the reset voltage VRST is applied. For example, the (6-5)-th conductive pattern 435 may be connected to the (5-1)-th conductive pattern 421 through the third contact hole CNT3.

The (6-2)-th conductive pattern 432 may configure the second electrode of the sixth pixel transistor TP6 or the first electrode of the light emitting element EE. For example, the (6-2)-th conductive pattern 432 may be connected to the (5-2)-th conductive pattern 422 through the third contact hole CNT3.

The (6-6)-th conductive pattern 436 may configure the second electrode of the third sensing transistor TS3 or the first electrode of the light receiving element OPD. For example, the (6-6)-th conductive pattern 436 may be connected to the (5-8)-th conductive pattern 428 through the third contact hole CNT3.

The display device may include a fourth contact hole CNT4. The fourth contact hole CNT4 may connect the sixth conductive layer 430 to a seventh conductive layer (e.g., 440 in FIG. 18) or an eighth conductive layer (e.g., 450 in FIG. 22), which will be described in more detail below. When the fourth contact hole CNT4 connects the sixth conductive layer 430 to the eighth conductive layer (e.g., 450 in FIG. 22), the fourth contact hole CNT4 may be connected to a fifth contact hole CNT5, which will be described in more detail below. For example, the fourth contact hole CNT4 may be a channel contact hole and/or a via contact hole.

Referring to FIG. 2 to FIG. 4 and FIG. 8 to FIG. 21, the display device may include the seventh conductive layer 440.

The seventh conductive layer 440 may include a metal, an alloy, a conductive metal oxide, a transparent conductive material, and/or the like. These may be used alone or in any suitable combination with each other.

The seventh conductive layer 440 may be disposed on the sixth conductive layer 430. The seventh conductive layer 440 may include a (7-1)-th conductive pattern 441.

The (7-1)-th conductive pattern 441 may be the reset voltage line to which the reset voltage VRST is applied. The (7-1)-th conductive pattern 441 may overlap with at least a portion of the readout line RL. For example, the (7-1)-th conductive pattern 441 may overlap with the (6-4)-th conductive pattern 434. As a portion of the (6-4)-th conductive pattern 434 overlaps with the (7-1)-th conductive pattern 441, the effect of coupling on the (6-4)-th conductive pattern 434 (e.g., the effect of coupling on the sensing signal) may be reduced.

The display device may include a fifth contact hole CNT5. The fifth contact hole CNT3 may connect the fourth contact hole CNT4 to the eighth conductive layer 450, which will be described in more detail below. For example, the fifth contact hole CNT5 may be a channel contact hole and/or a via contact hole.

Referring to FIG. 2 to FIG. 4 and FIG. 8 to FIG. 23, the display device may include the eighth conductive layer 450.

The eighth conductive layer 450 may include a metal, an alloy, a conductive metal oxide, a transparent conductive material, and/or the like. These may be used alone or in any suitable combination with each other.

The eighth conductive layer 450 may be disposed on the seventh conductive layer 440. The eighth conductive layer 450 may include (8-1)-th conductive patterns 451a, 451b, and 451c, and a (8-2)-th conductive pattern 452.

The (8-1)-th conductive patterns 451a, 451b, and 451c may configure the second electrode of the sixth pixel transistor TP6 or the first electrode of the light emitting element EE. For example, the (8-1)-th conductive patterns 451a, 451b, and 451c may be connected to the (6-2)-th conductive pattern 432 through the fourth contact hole CNT4 and the fifth contact hole CNT5.

In an embodiment, the (8-1)-th conductive pattern 451a may configure a first electrode of the light emitting element EE for displaying a first color, the (8-1)-th conductive pattern 451b may configure a first electrode of the light emitting element EE for displaying a second color, and the (8-1))-th conductive pattern 451c may configure a first electrode of the light emitting element EE for displaying a third color.

The (8-2)-th conductive pattern 452 may configure the second electrode of the third sensing transistor TS3 or the first electrode of the light receiving element OPD. For example, the (8-2)-th conductive pattern 452 may be connected to the (6-6)-th conductive pattern 436 through the fourth contact hole CNT4 and the fifth contact hole CNT5.

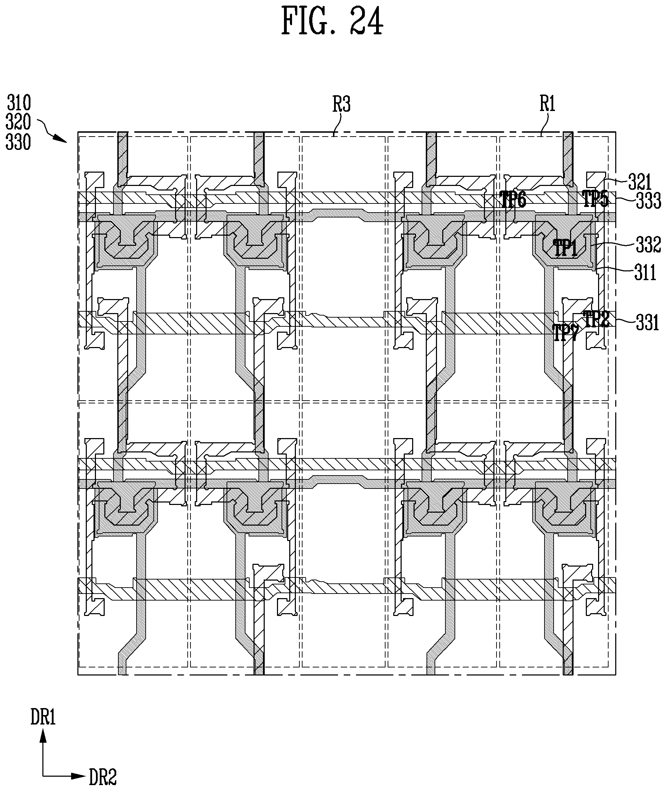

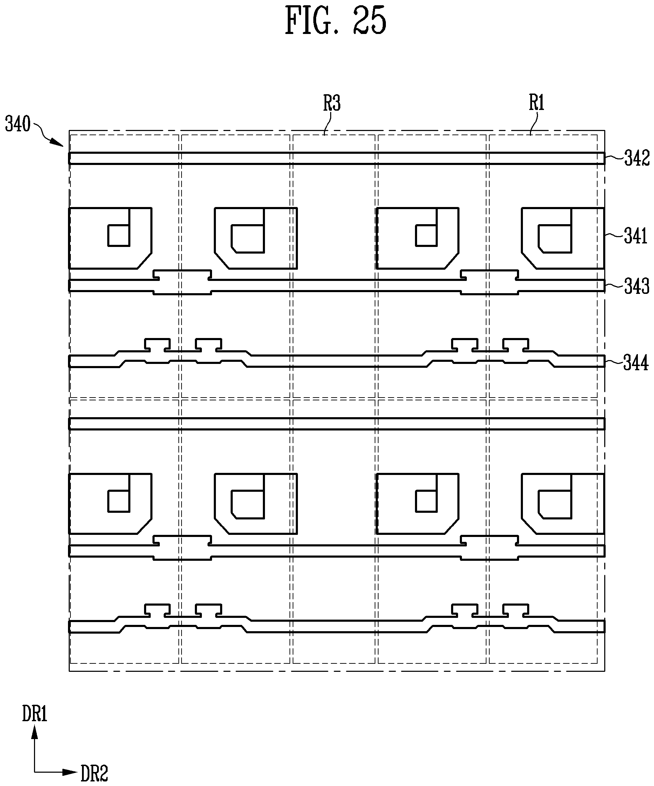

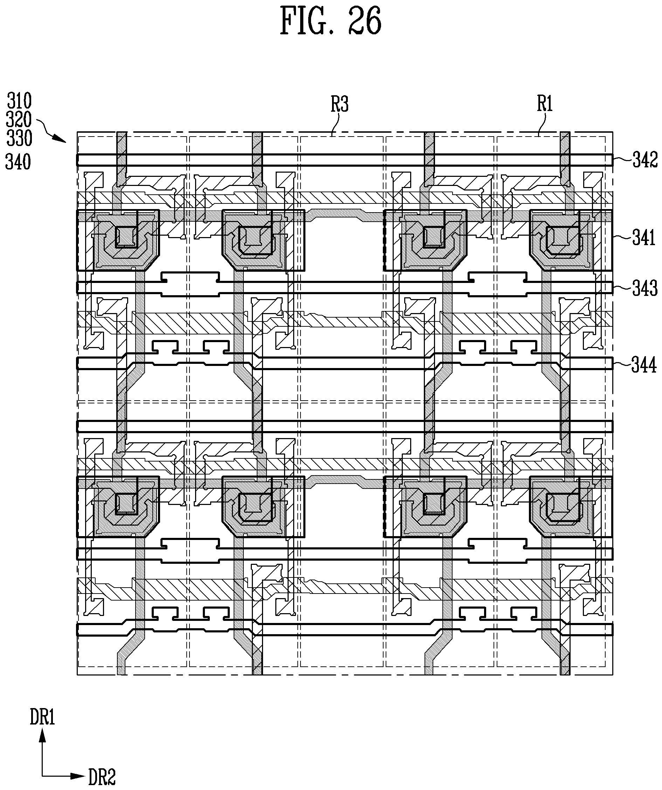

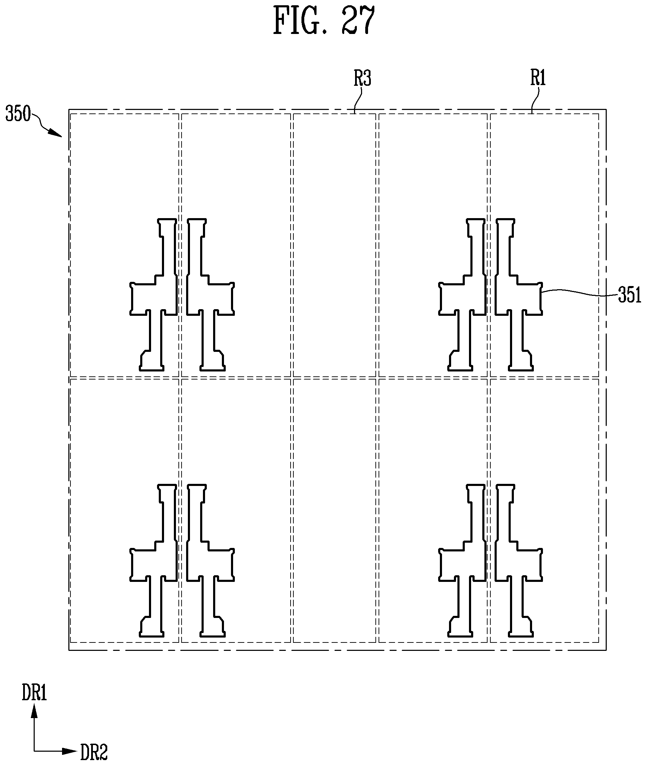

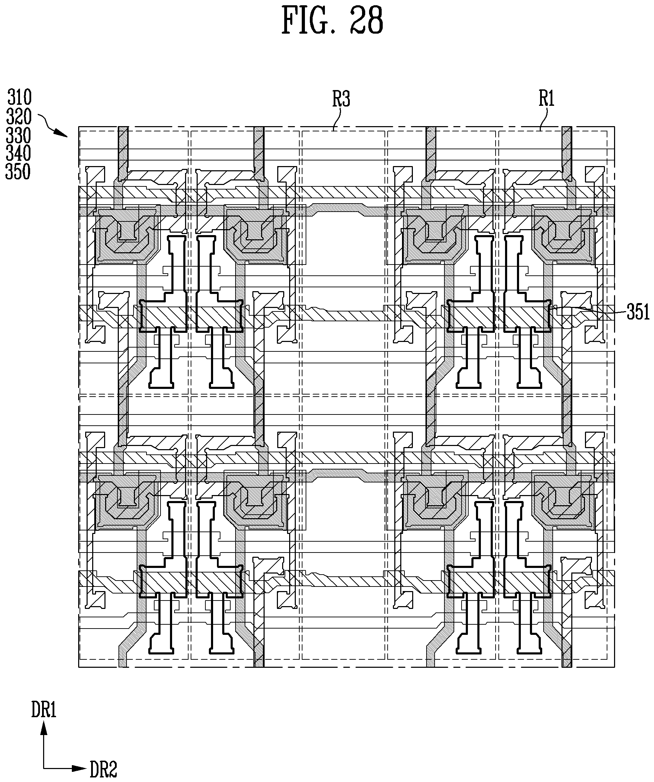

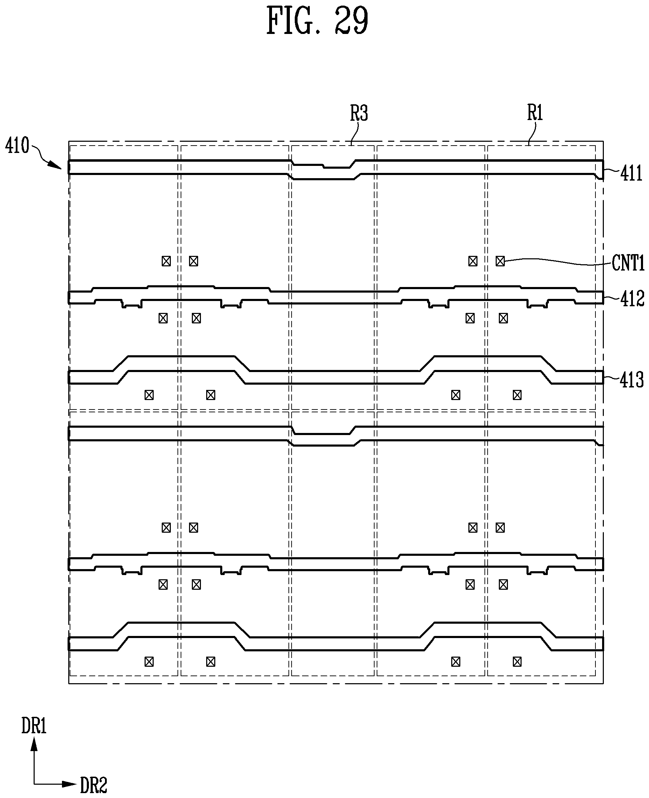

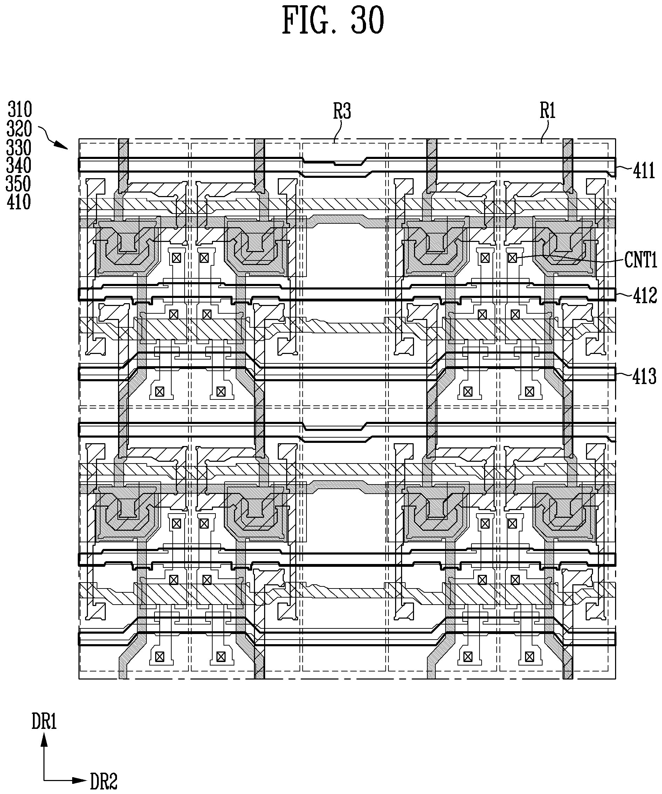

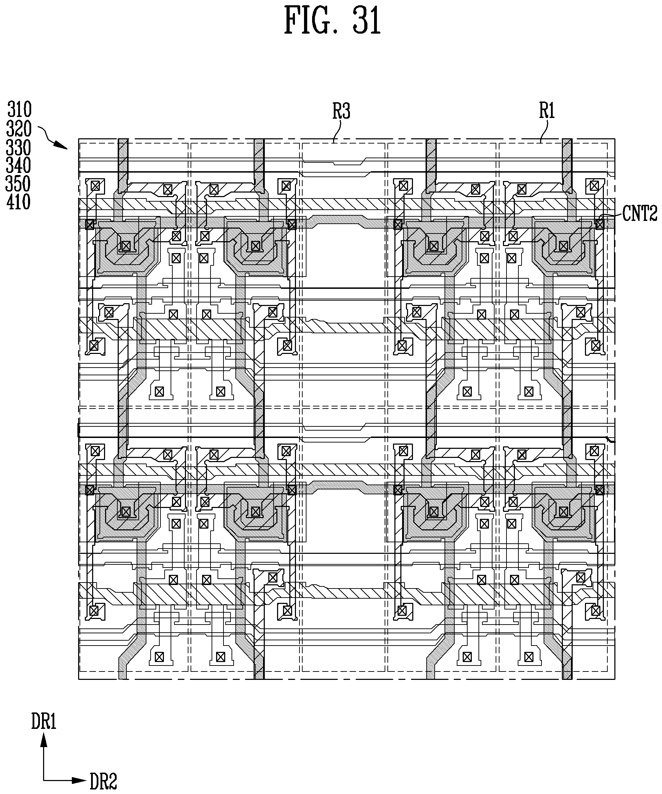

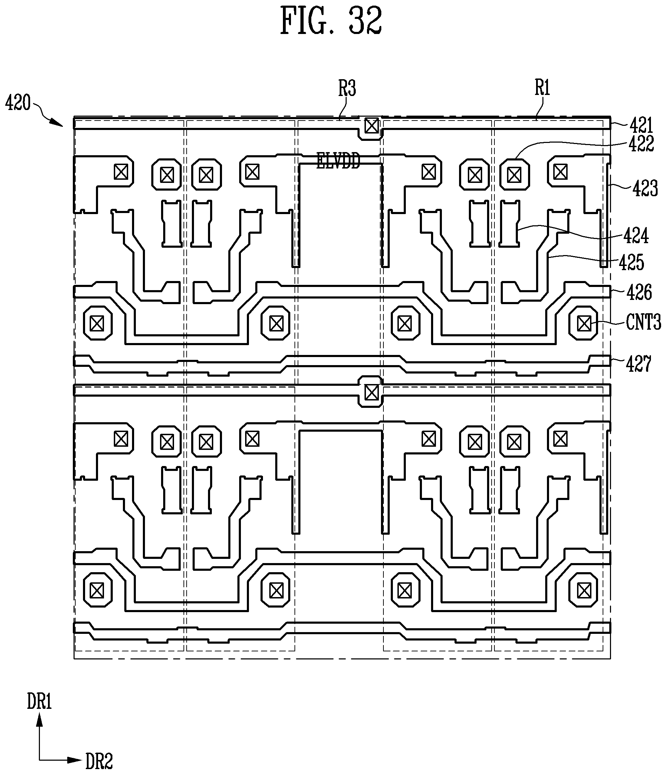

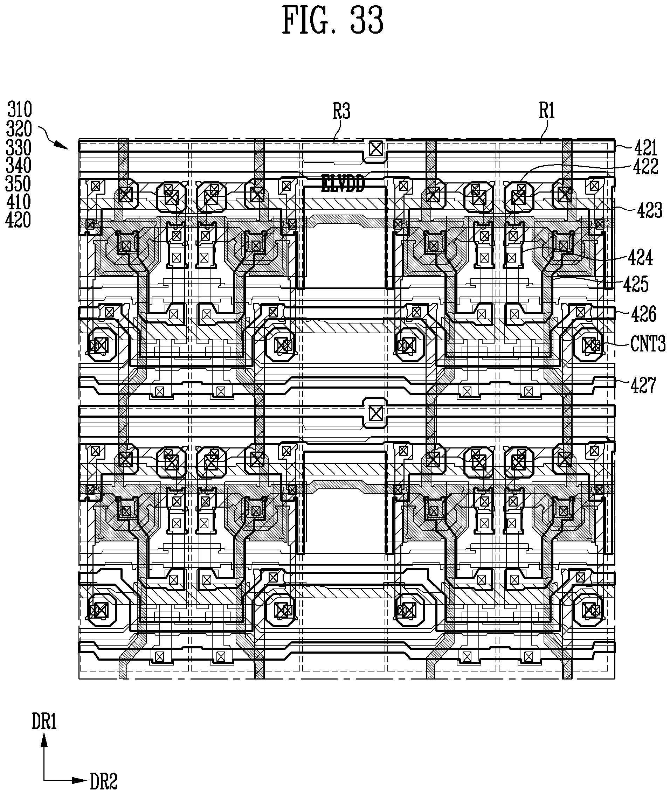

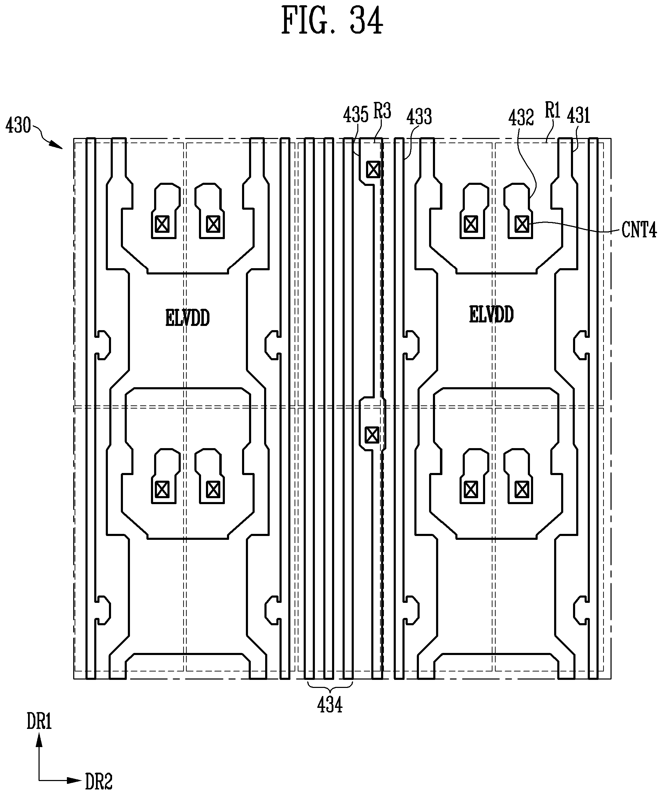

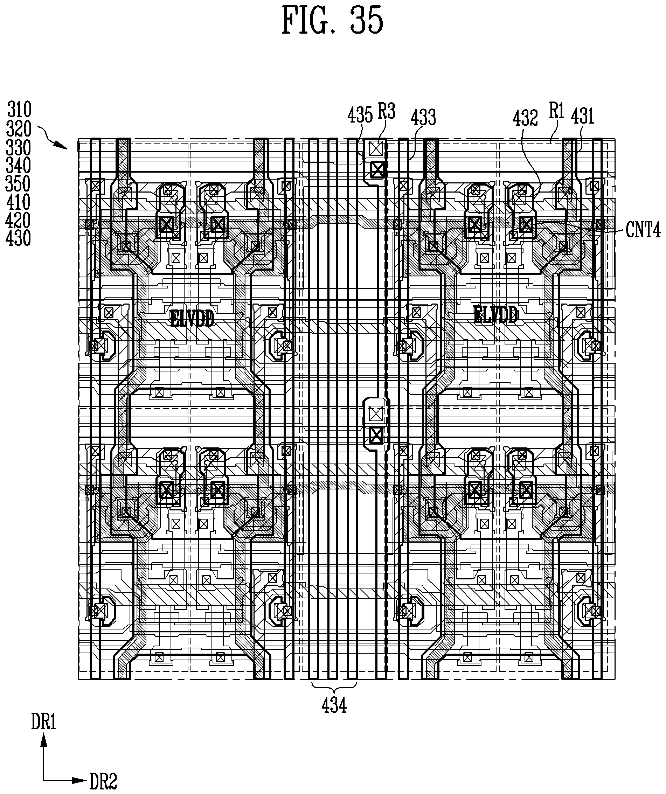

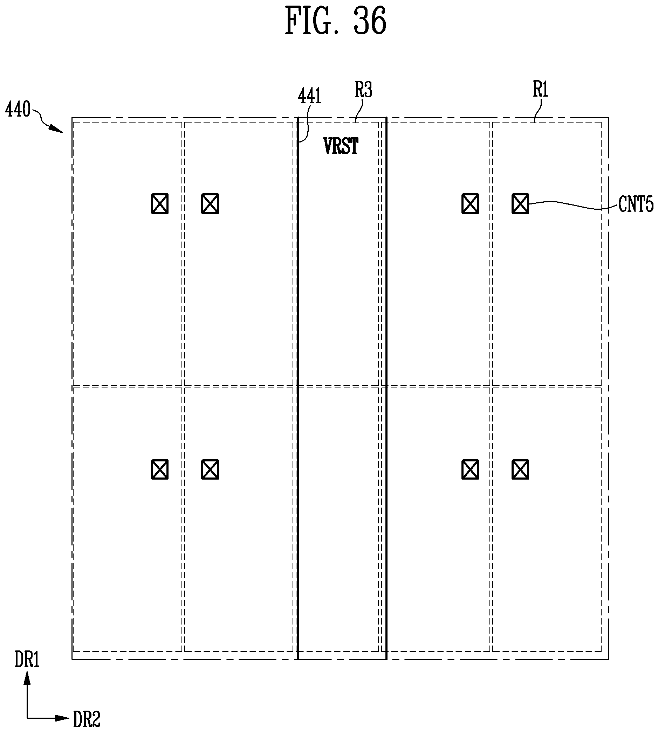

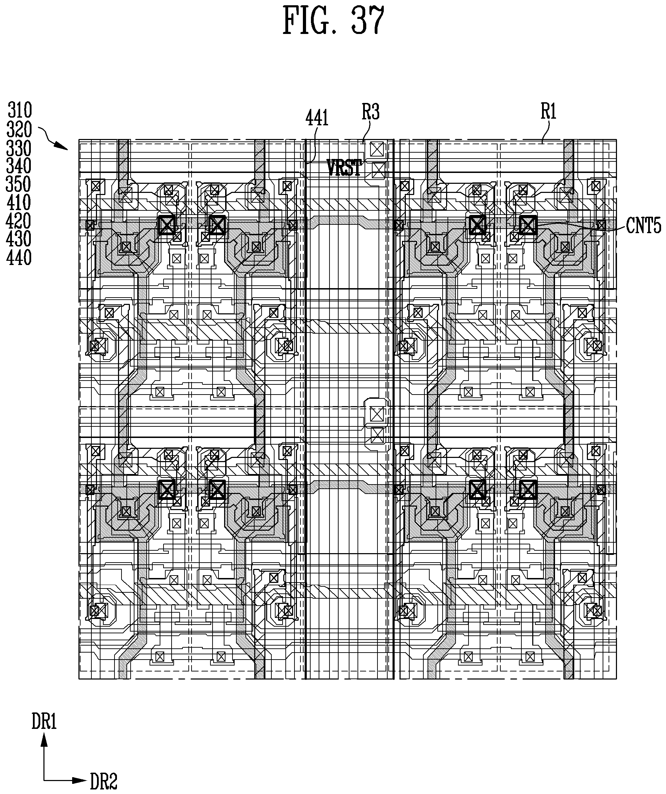

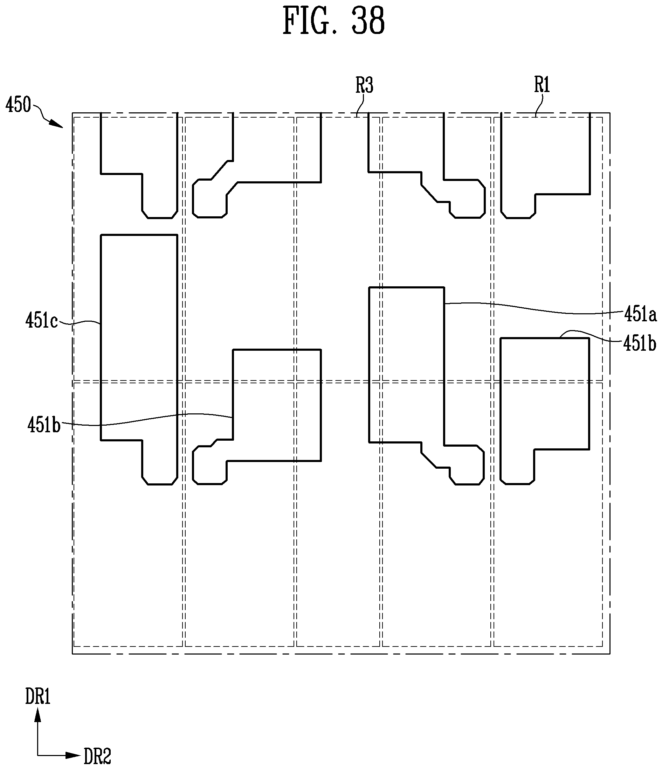

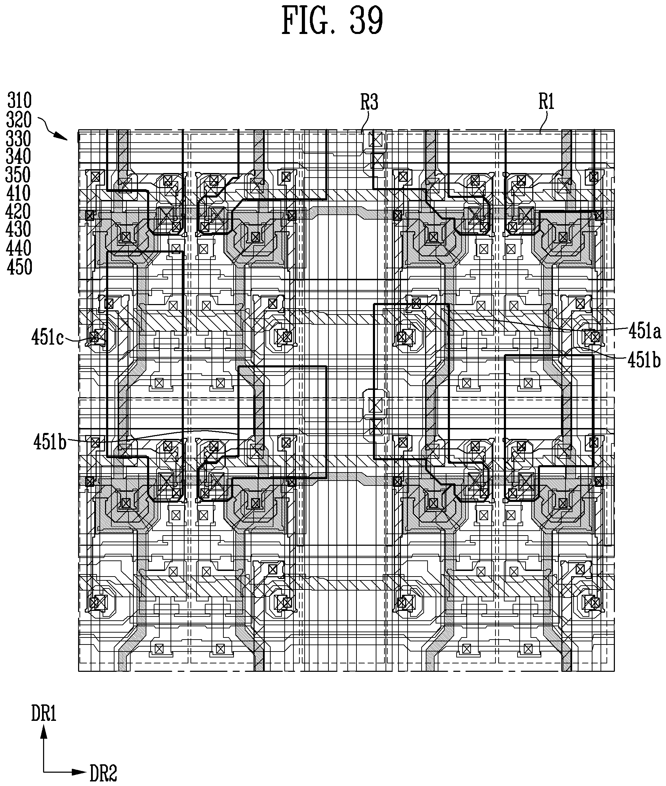

FIG. 24 through FIG. 39 illustrate layout views of an example of a non-sensing area of the display device of FIG. 1.

The non-sensing area according to the present embodiment may have the same or substantially the same configuration as the configuration of the sensing area described above, except for a third area R3. In FIGS. 24 through 39, the same reference numerals and reference symbols are used to denote the same or substantially the same (or similar) constituent elements as described above, and thus, redundant description may not be repeated.

Referring to FIG. 2 to FIG. 4 and FIG. 24 to FIG. 26, the non-sensing area NSA may include the first area R1 including the pixel driving circuit PC, and the third area R3 adjacent to the first area R1. The third area R3 corresponds to the second area R2 described above, but may not include the sensor driving circuit LC. Accordingly, the third area R3 may not include the (1-2)-th active pattern (e.g., 322 in FIG. 8) and the (2-4)-th conductive pattern (e.g., 334 in FIG. 8).

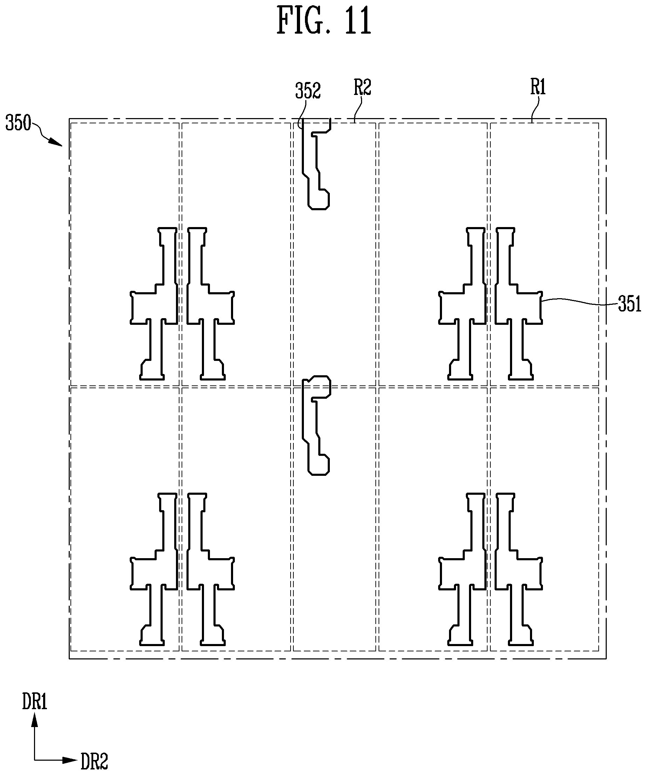

Referring to FIG. 2 to FIG. 4 and FIG. 24 to FIG. 31, the third area R3 corresponds to the second area R2 described above, but may not include the sensor driving circuit LC. Accordingly, the third area R3 may not include the (2-2)-th active pattern (e.g., 352 in FIG. 11).

Referring to FIG. 2 to FIG. 4 and FIG. 24 to FIG. 33, the third area R3 corresponds to the second area R2 described above, but may not include the sensor driving circuit LC. Accordingly, the third area R3 may not include the (5-8)-th conductive pattern 428 and the (5-9)-th conductive pattern 429.

Referring to FIG. 2 to FIG. 4 and FIG. 24 to FIG. 35, the third area R3 corresponds to the second area R2 described above, but may not include the sensor driving circuit LC. Accordingly, the third area R3 may not include the (6-6)-th conductive pattern 436.

In addition, because the third area R3 does not include the sensor driving circuit LC, the third area R3 may sufficiently secure a space (e.g., a space for the (6-4)-th conductive pattern 434) for the readout line RL when compared to the second area. Accordingly, the third area R3 when compared to the second area may include many readout lines RL (e.g., the (6-4)-th conductive pattern 434).

In addition, because the third area R3 does not include the sensor driving circuit LC, the effect of coupling on the readout line RL (e.g., the effect of coupling on the sensing signal) may be reduced.

In the present embodiment, the third area R3 is shown to include three (6-4)-th conductive patterns 434, but the present disclosure is not limited to the number of (6-4)-th conductive patterns 434 shown in the drawings.

Referring to FIG. 2 to FIG. 4 and FIG. 24 to FIG. 39, the third area R3 corresponds to the second area R2 described above, but may not include the sensor driving circuit LC. Accordingly, the third area R3 may not include the (8-2)-th conductive pattern 452.

In an embodiment, the size of the first area R1 in the sensing area SA may be smaller than the size of the first area R1 in the non-sensing area NSA. Because the non-sensing area NSA does not include the sensor driving circuit LC, the size of the third area R3 may be smaller than the size of the second area R2. In addition, as the size of the third area R3 decreases, the size of the first area R1 in the non-sensing area NSA may increase.

In an embodiment, the number of the readout lines RL (e.g., the (6-4)-th conductive pattern 434) disposed in one third area R3 may be increased as the resolution of the display panel 100 increases.

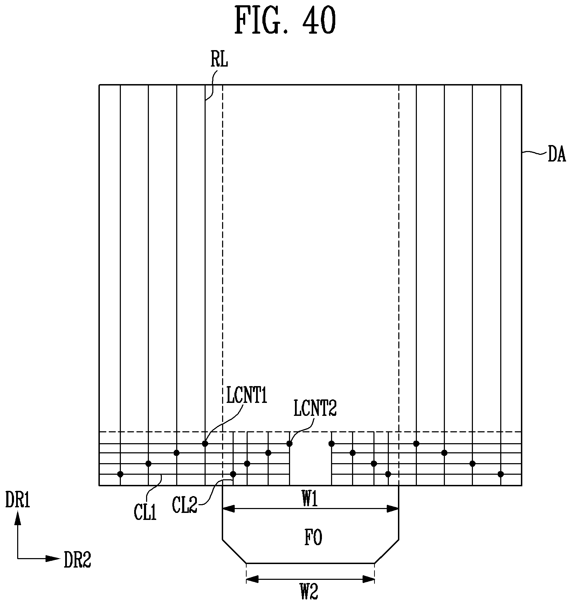

FIG. 40 illustrates an example of a readout line disposed in a second display area of a display device according to one or more embodiments of the present disclosure.

Because the display device according to the present embodiment may have the same or substantially the same configuration as the configuration of the display device described above with reference to FIG. 1, except for the readout line RL and the connection lines CL1 and CL2, the same reference numbers and reference symbols are used to denote the same or substantially the same (or similar) constituent elements as those described above. Accordingly, redundant description may not be repeated.

Referring to FIG. 40, the first connection line CL1 and the second connection line CL2 may form a mesh structure. For example, the first connection line CL1 may extend in the second direction DR2. For example, the second connection line CL2 may extend in the first direction DR1. For example, the first connection line CL1 may extend to cross or intersect the second connection line CL2.

The readout line RL and the first connection line CL1 may form a mesh structure. For example, the readout line RL may extend in the first direction DR1. For example, the first connection line CL1 may extend in the second direction DR2. For example, the readout line RL may extend to cross or intersect the first connection line CL1.

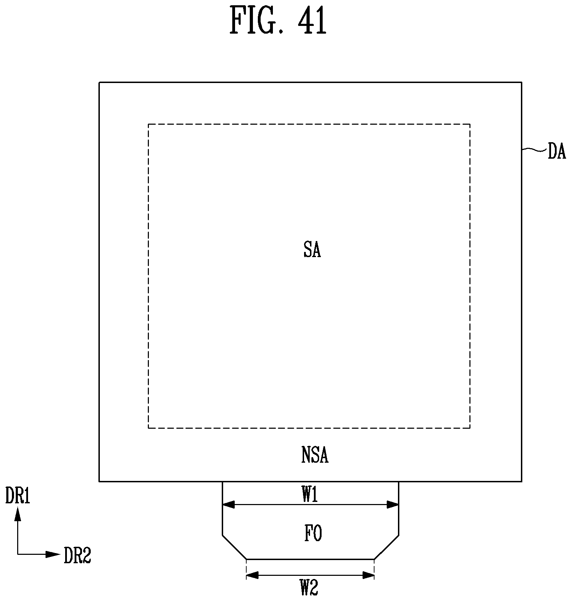

FIG. 41 illustrates an example of a sensing area and a non-sensing area of a display device according to one or more embodiments of the present disclosure.

Because the display device according to the present embodiment may have the same or substantially the same configuration as the configuration of the display device described above with reference to FIG. 1, except for the sensing area SA, the non-sensing area NSA, the readout line RL, and the connection lines CL1, CL2, CL3, and CL4, the same reference numbers and reference symbols are used to denote the same or substantially the same (or similar) constituent elements as those described above. Accordingly, redundant description may not be repeated.

Referring to FIG. 1 to FIG. 3 and FIG. 41, the non-sensing area NSA may be adjacent to the connection portion FO in the first direction DR1. The non-sensing area NSA may be formed to surround (e.g., around a periphery of) the sensing area SA.

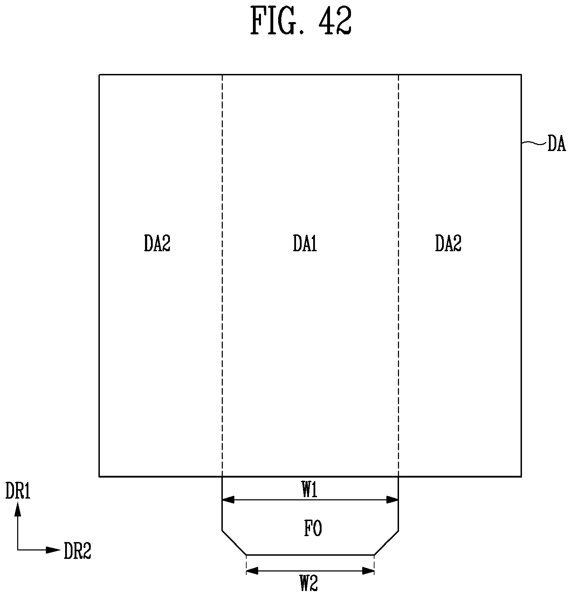

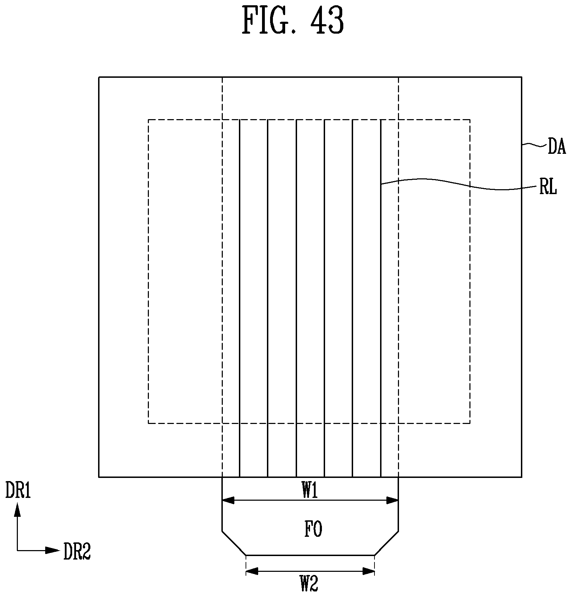

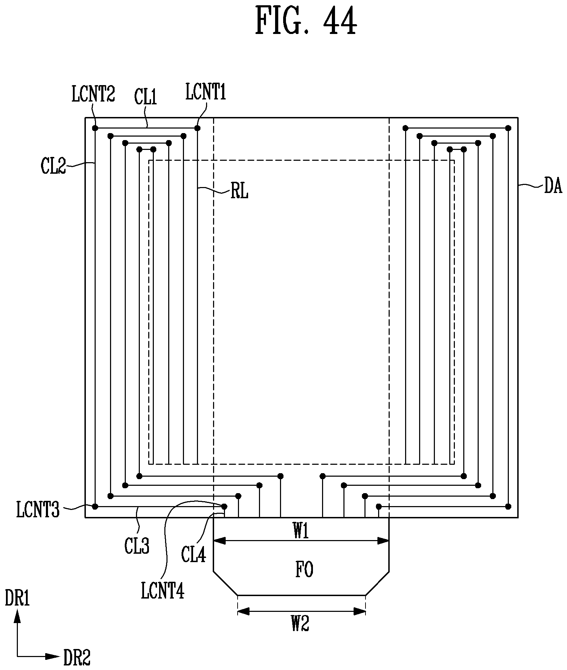

FIG. 42 illustrates an example of a first display area and a second display area of the display device of FIG. 41. FIG. 43 illustrates an example of a readout line disposed in a first display area of the display device of FIG. 41. FIG. 44 illustrates an example of a readout line disposed in a second display area of the display device of FIG. 41.

Referring to FIG. 1 to FIG. 3 and FIG. 41 to FIG. 44, the connection lines CL1, CL2, CL3, and CL4 connecting the readout line RL and the connection portion FO to each other may be disposed in the non-sensing area NSA. When the connection lines CL1, CL2, CL3, and CL4 are disposed in the sensing area SA, coupling may occur between the connection lines CL1, CL2, CL3, and CL4 and the sensor driving circuit LC. In this case, the sensing signal may be distorted, and the accuracy of sensing by the optical sensor LS may decrease.

For example, the readout line RL may extend in the first direction DR1. The connection lines CL1, CL2, CL3, and CL4 may include a first connection line CL1, a second connection line CL2, a third connection line CL3, and a fourth connection line CL4. The first connection line CL1 may extend in the second direction DR2 crossing the first direction DR1, and may be connected to the readout line RL through the first line contact hole LCNT1. The second connection line CL2 may extend in the first direction DR1, and may be connected to the first connection line CL1 through the second line contact hole LCNT2. The third connection line CL3 may extend in the second direction DR2, and may be connected to the second connection line CL2 through a third line contact hole LCNT3. The fourth connection line CL4 may extend in the first direction DR1, and may be connected to the third connection line CL3 through a fourth line contact hole LCNT4. For example, the fourth connection line CL4 may be connected to the connection portion FO.

In an embodiment, the fourth connection line CL4 may form a mesh structure with the third connection line CL3. In an embodiment, the third connection line CL3 may form a mesh structure with the second connection line CL2. In an embodiment, the second connection line CL2 may form a mesh structure with the first connection line CL1. In an embodiment, the first connection line CL1 may form a mesh structure with the readout line RL.

In an embodiment, the readout line RL may be formed at (e.g., in or on) the same layer as that of the second connection line CL2. In an embodiment, the first connection line CL1 may be formed at (e.g., in or on) the same layer as that of the third connection line CL3. In an embodiment, the fourth connection line CL4 may be formed at (e.g., in or on) a different layer from those of the readout line RL and the first to third connection lines CL1, CL2, and CL3. However, the present disclosure is not limited thereto, and the layer in which the connection lines CL1, CL2, CL3, and CL4 and the readout line RL are formed may be various modified as needed or desired.

In an embodiment, the first to fourth line contact holes LCNT1, LCNT2, LCNT3, and LCNT4 may be channel contact holes and/or via contact holes. For example, when an organic film is disposed between the second connection line CL2 and the third connection line CL3, the third line contact hole LCNT3 may be a channel contact hole. When an inorganic film is disposed between the second connection line CL2 and the third connection line CL3, the third line contact hole LCNT3 may be a via contact hole. When an organic film and an inorganic film are disposed between the second connection line CL2 and the third connection line CL3, the third line contact hole LCNT3 may include both a channel contact hole and a via contact hole. For example, when an organic film is disposed between the third connection line CL3 and the fourth connection line CL4, the fourth line contact hole LCNT4 may be a channel contact hole. When an inorganic film is disposed between the third connection line CL3 and the fourth connection line CL4, the fourth line contact hole LCNT4 may be a via contact hole. When an organic film and an inorganic film are disposed between the third connection line CL3 and the fourth connection line CL4, the fourth line contact hole LCNT4 may include both a channel contact hole and a via contact hole.

As the lengths of the connection lines CL1, CL2, CL3, and CL4 increase, the widths of the connection lines CL1, CL2, CL3, and CL4 may increase. A load of each connection line CL1, CL2, CL3, or CL4 may vary depending on the lengths of the connection lines CL1, CL2, CL3, and CL4. In other words, the strength of the sensing signal may vary depending on the connection lines CL1, CL2, CL3, and CL4. Accordingly, the display device may minimize or reduce a load difference between the connection lines CL1, CL2, CL3, and CL4 by disposing a line having a wider width as the lengths of the connection lines CL1, CL2, CL3, and CL4 increase.

For example, the first connection line CL1 may become longer as it goes outward. In this case, the width of the first connection line CL1 may become wider toward the outside.

For example, the second connection line CL2 may become longer as it goes outward. In this case, the width of the second connection line CL2 may become wider toward the outside.

For example, the fourth connection line CL4 may become longer as it is connected to the central portion of the connection portion FO. In this case, the width of the fourth connection line CL4 may become wider toward the central portion of the connection portion FO.

In an embodiment, the length of the connected connection lines CL1, CL2, CL3, and CL4 may become longer toward the outside. In this case, the widths of the first to fourth connecting lines CL1, CL2, CL3, and CL4 may become wider toward the outside.

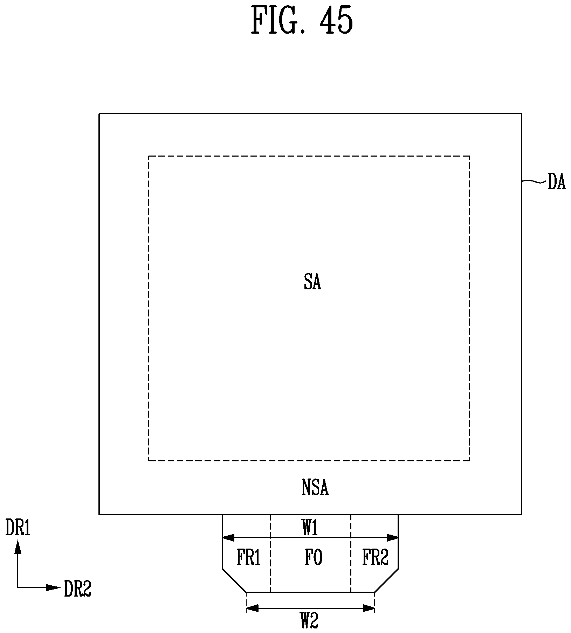

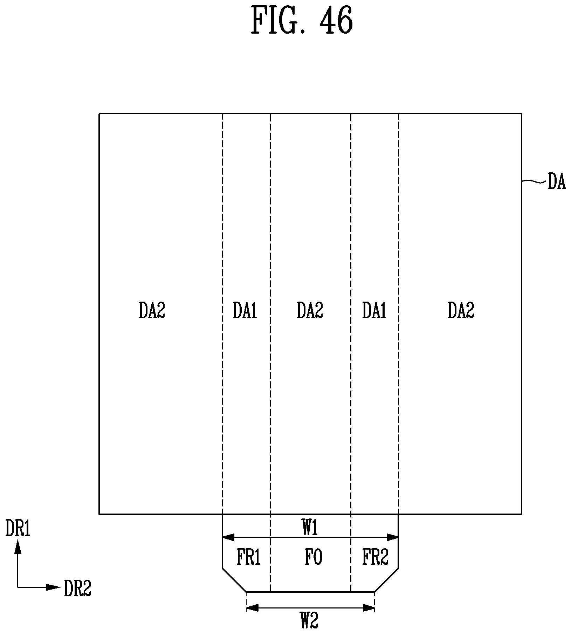

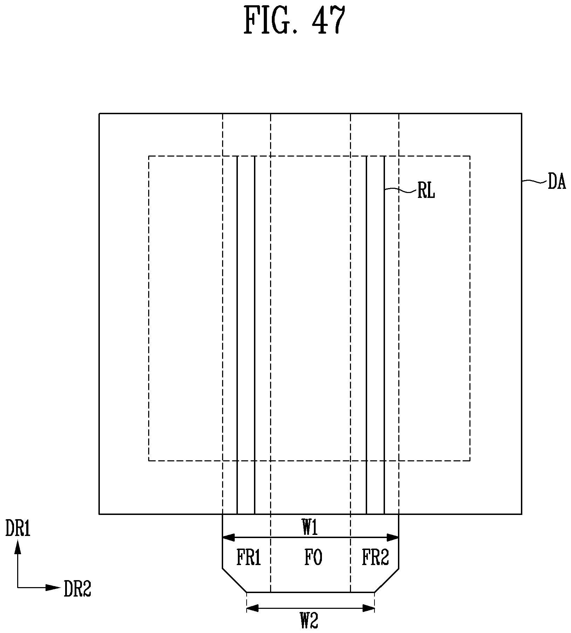

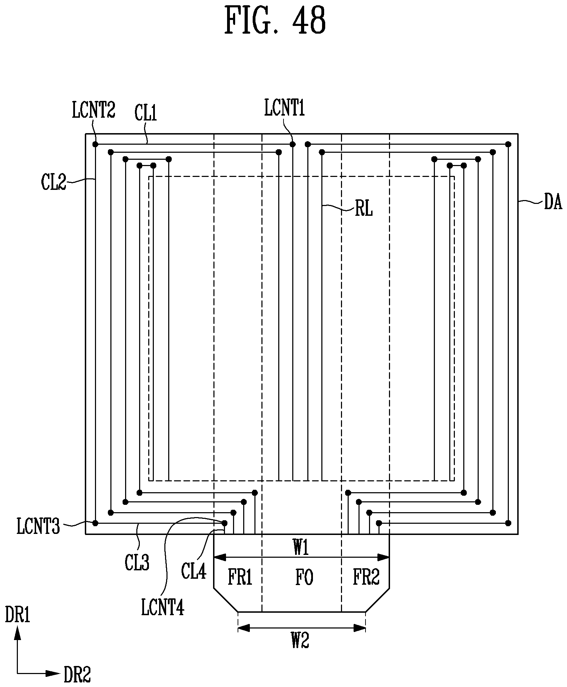

FIG. 45 illustrates an example of a sensing area and a non-sensing area of a display device according to one or more embodiments of the present disclosure. FIG. 46 illustrates an example of a first display area and a second display area of the display device of FIG. 45. FIG. 47 illustrates an example of a readout line disposed in a first display area of the display device of FIG. 45. FIG. 48 illustrates an example of a readout line disposed in a second display area of the display device of FIG. 45.

Because the display device according to the present embodiment may have the same or substantially the same configuration as the configuration of the display device in FIG. 41, except for the first display area DA1 and the second display area DA2, the same reference numbers and reference symbols are used to denote the same or substantially the same (or similar) constituent elements as those described above. Accordingly, redundant description may not be repeated.

Referring to FIG. 1 to FIG. 3 and FIG. 45 to FIG. 48, the connection portion FO may include a first connection area FR1, and a second connection area FR2 spaced apart from the first connection area FR1. The display area DA may include a first display area DA1 adjacent to the first connection area FR1 and the second connection area FR2 in the first direction DR1, and a second display area DA2.

The connection portion FO may include the first connection area FR1 and the second connection area FR2 that connect the readout line RL to the readout circuit 600. In an embodiment, the connection portion FO may connect the data line DL to the data driver 400 in areas excluding the first connection area FR1 and the second connection area FR2. In another embodiment, the connection portion FO may connect the data line DL to the data driver 400 through an area formed at (e.g., in or on) a different layer from that of the first connection area FR1 and the second connection area FR2.

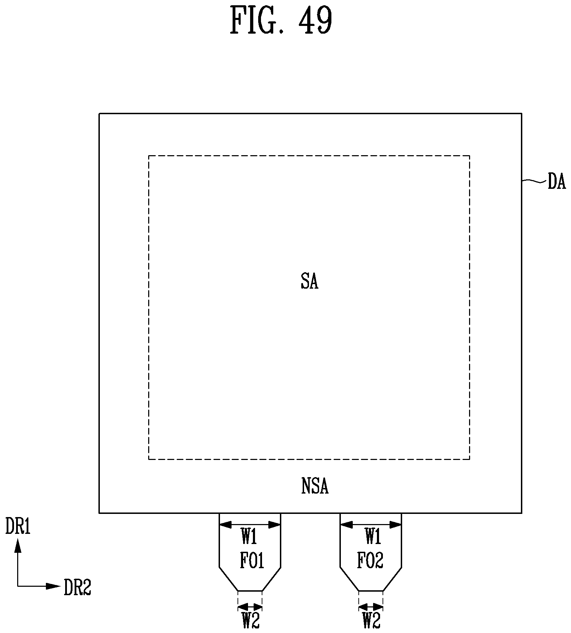

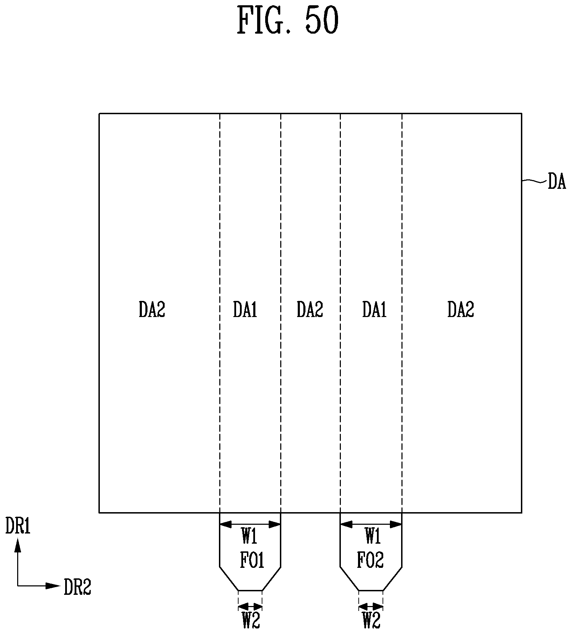

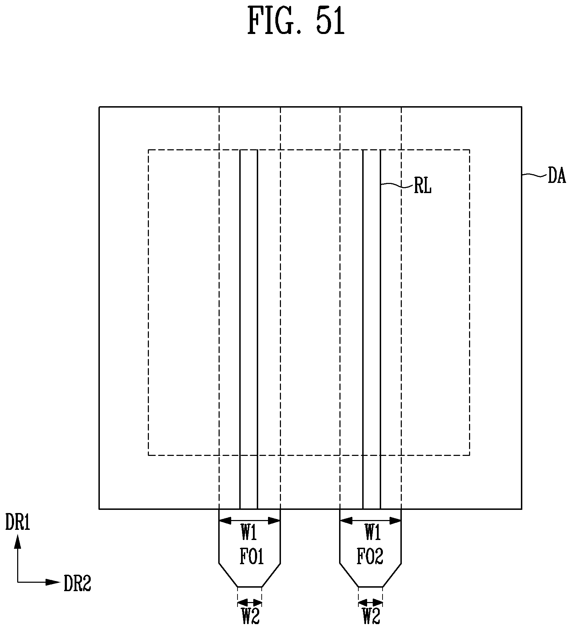

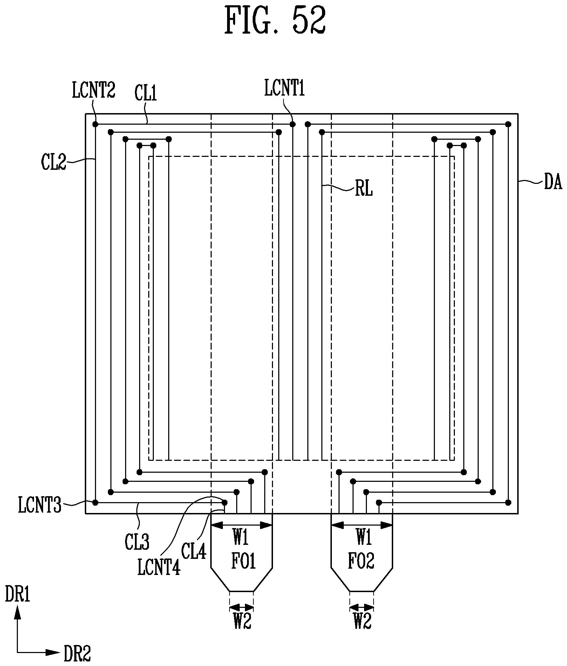

FIG. 49 illustrates an example of a sensing area and a non-sensing area of a display device according to one or more embodiments of the present disclosure. FIG. 50 illustrates an example of a first display area and a second display area of the display device of FIG. 49. FIG. 51 illustrates an example of a readout line disposed in a first display area of the display device of FIG. 49. FIG. 52 illustrates an example of a readout line disposed in a second display area of the display device of FIG. 49.

Because the display device according to the present embodiment may have the same or substantially the same configuration as the configuration of the display device described above with reference to FIG. 41, except for the first and second connection portions FO1 and FO2, the same reference numbers and reference symbols are used to denote the same or substantially the same (or similar) constituent elements as those described above. Accordingly, redundant description may not be repeated.

Referring to FIG. 1 to FIG. 3 and FIG. 45 to FIG. 48, the display device may include a first connection portion FO1 that electrically connects the readout line RL to the readout circuit 600, and a second connection portion FO2 that electrically connects the readout line RL to the readout circuit 600. The second connection portion FO2 may be spaced apart from the first connection portion FO1. In an embodiment, the width W1 of a first surface (e.g., a first end) of the first and second connection portions FO1 and FO2 that are adjacent to the display area DA may be longer than the width W2 of a second surface (e.g., a second end) of the first and second connection portions FO1 and FO2 that are connected to the readout circuit 600.

The readout line RL may extend in the first direction DR1. The display area DA may include a first display area DA1 adjacent to the first and second connection portions FO1 and FO2 in the first direction DR1, and a second display area DA2. The connection lines CL1, CL2, CL3, and CL4 may connect the readout line RL of the second display area DA2 to the first and second connection portions FO1 and FO2.

The readout line RL of the first display area DA1 may extend in the first direction DR1 to be directly connected to the first and second connection portions FO1 and FO2. However, the readout line RL of the second display area DA2 may employ an additional wire to be connected to the first and second connection portions FO1 and FO2. Accordingly, the readout line RL of the second display area DA2 may be connected to the first and second connection portions FO1 and FO2 through the connection lines CL1, CL2, CL3, and CL4.

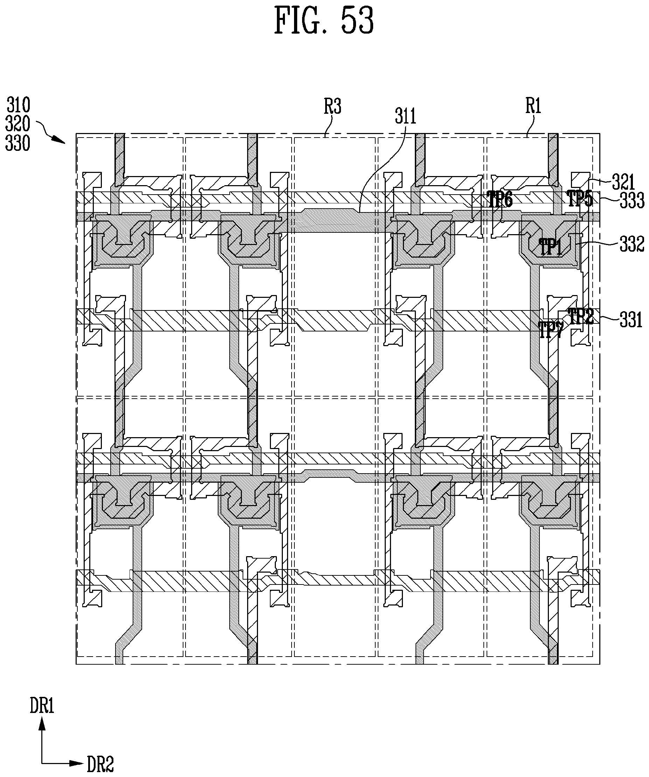

FIG. 53 illustrates a layout view of a first conductive layer, a first active layer, and a second conductive layer of a display device according to one or more embodiments of the present disclosure.

Because the display device according to the present embodiment may have the same or substantially the same configuration as the configuration of the display device in FIG. 1, except for the (1-1)-th conductive pattern 311 and the (2-1)-th conductive pattern 331 in the third area R3, the same reference numbers and reference symbols are used to denote the same or substantially the same (or similar) constituent elements as those described above. Accordingly, redundant description may not be repeated.

Referring to FIG. 8 and FIG. 53, the width of the (1-1)-th conductive pattern 311 in the third area R3 may be wider than the width of the (1-1)-th conductive pattern 311 in the second area R2. The third area R3 may have a sufficient extra space compared to the second area R2. Accordingly, by increasing the width of the (1-1)-th conductive pattern 311 in the third area R3, the resistance of the (1-1)-th conductive pattern 311 in the third area R3 may be lowered.

The width of the (2-1)-th conductive pattern 331 in the third area R3 may be wider than the width of the (2-1)-th conductive pattern 331 in the second area R2. The third area R3 may have a sufficient extra space compared to the second area R2. Accordingly, by increasing the width of the (2-1)-th conductive pattern 331 in the third area R3, the resistance of the (2-1)-th conductive pattern 331 in the third area R3 may be lowered.

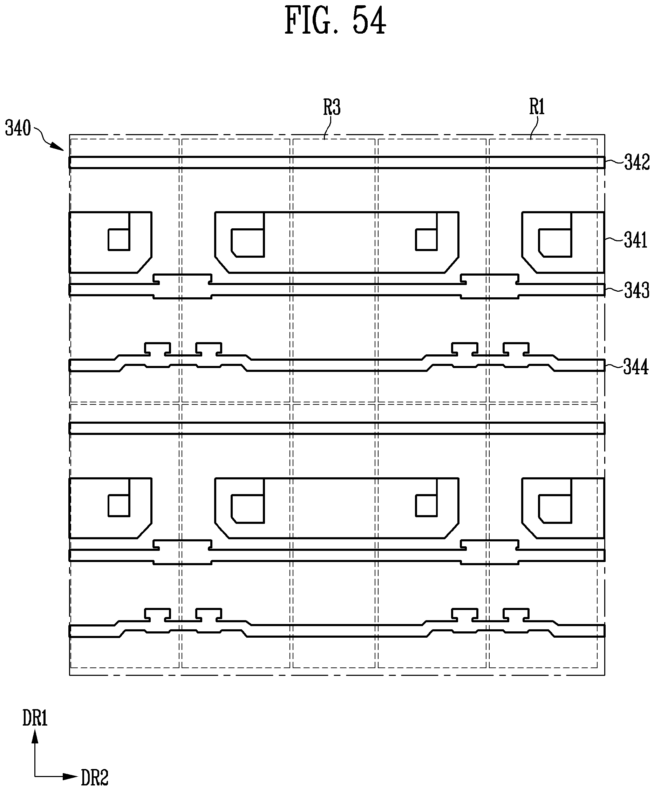

FIG. 54 illustrates a layout view of a third conductive layer of a display device according to one or more embodiments of the present disclosure.

Because the display device according to the present embodiment may have the same or substantially the same configuration as the configuration of the display device described above with reference to FIG. 1, except for the (3-1)-th conductive pattern 341 in the third area R3, the same reference numbers and reference symbols are used to denote the same or substantially the same (or similar) constituent elements as those described above. Accordingly, redundant description may not be repeated.

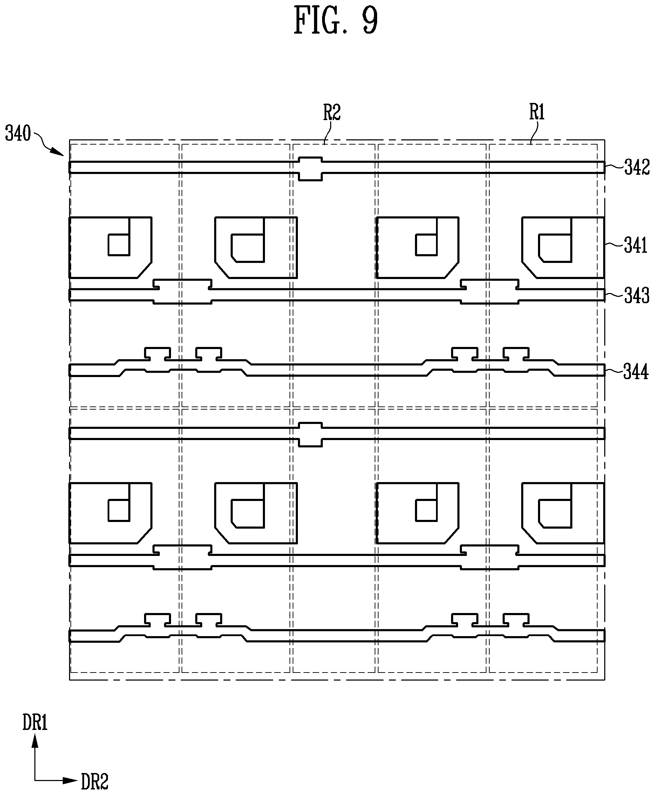

Referring to FIG. 9 and FIG. 54, at least a portion of the (3-1)-th conductive pattern 341 may be included in the third area R3. The third area R3 may have a sufficient extra space compared to the second area R2. Accordingly, the (3-1)-th conductive patterns 341 adjacent to the third area R3 may be connected to each other through the third area R3. In other words, by connecting the (3-1) conductive patterns 341 to each other in the third area R3, the resistance of the (3-1)-th conductive patterns 341 may be reduced.

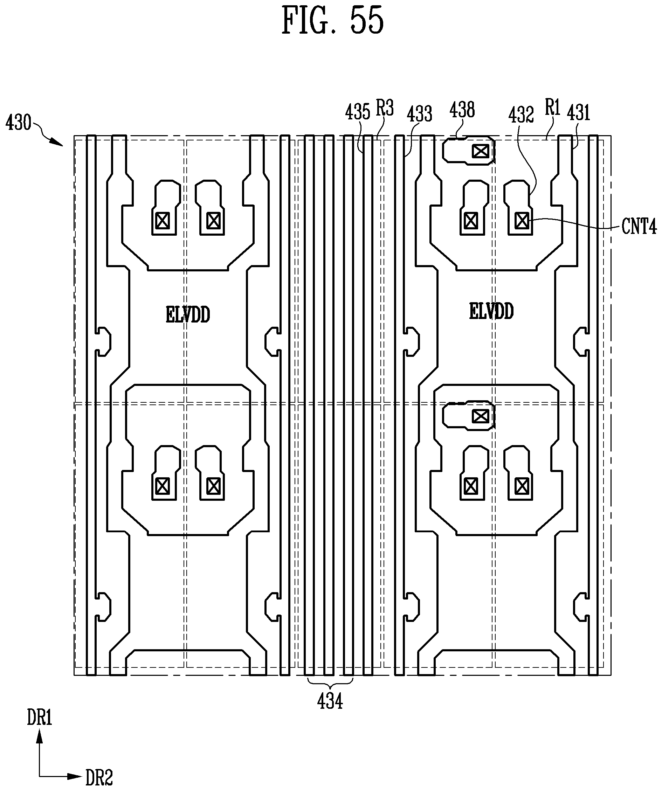

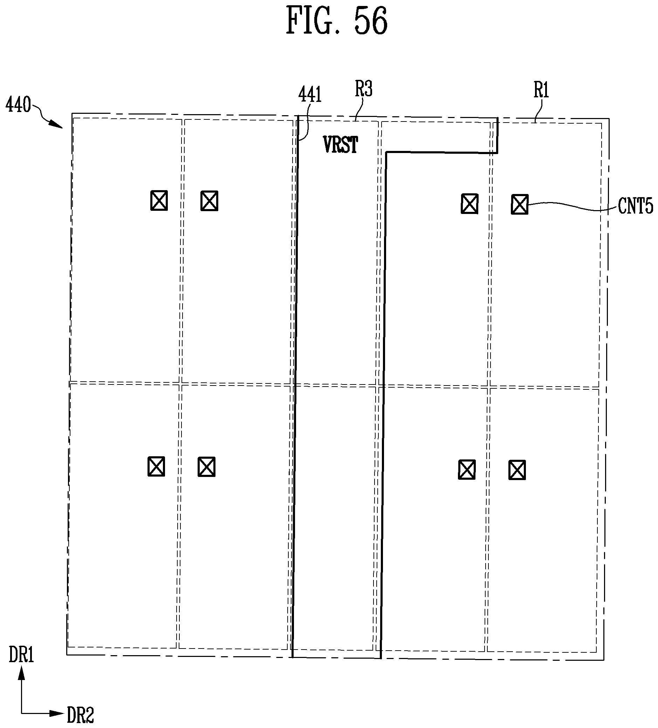

FIG. 55 illustrates a layout view of a sixth conductive layer of a display device according to one or more embodiments of the present disclosure. FIG. 56 illustrates a layout view of a seventh conductive layer of the display device of FIG. 55.

Because the display device according to the present embodiment may have the same or substantially the same configuration as the configuration of the display device described above with reference to FIG. 1, except for the (6-5)-th conductive pattern 435, the (6-8)-th conductive pattern 438, and the (7-1)-th conductive pattern 441 in the third area R3, the same reference numbers and reference symbols are used to denote the same or substantially the same (or similar) constituent elements as those described above. Accordingly, redundant description may not be repeated.

Referring to FIG. 18, FIG. 33, FIG. 55, and FIG. 56, the display device may include a (6-8)-th conductive pattern 438. At least a portion of the (6-8)-th conductive pattern 438 may overlap with the first area R1. The (6-8)-th conductive pattern 438 may be connected to the (5-1)-th conductive pattern 421 and the (7-1)-th conductive pattern 441. In other words, the reset voltage VRST may be applied to the (6-8)-th conductive pattern 438.

For example, the (6-8)-th conductive pattern 438 may be disposed in one of the first area R1 adjacent to the third area R3 in the second direction DR2 and/or the first area R1 adjacent to the third area R3 in an opposite direction to the second direction DR2.

In an embodiment, the (6-5)-th conductive pattern 435 may not be connected to the (7-1)-th conductive pattern 441 in the third area R3. In other words, the fourth contact hole CNT4 connecting the (6-5)-th conductive pattern 435 to the (7-1)-th conductive pattern 441 may be disposed in the second area R2.

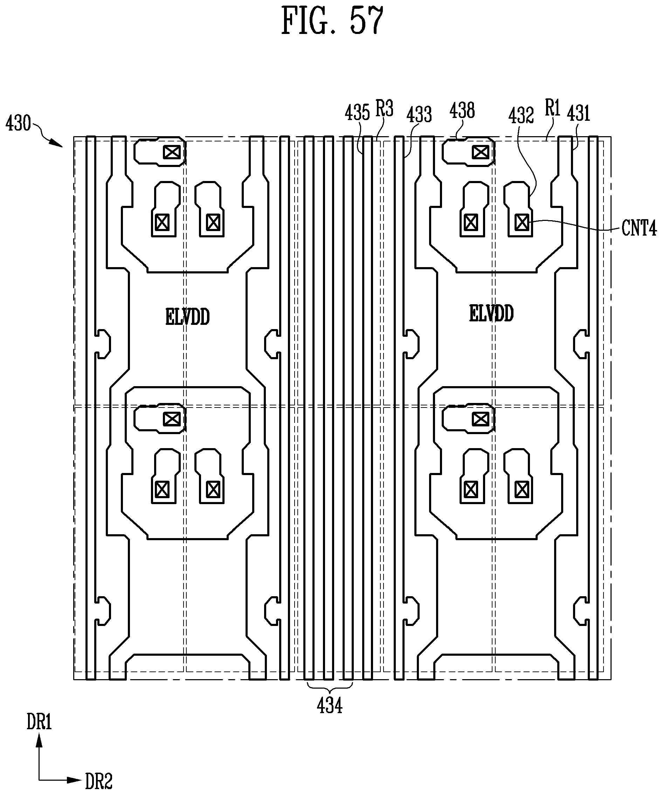

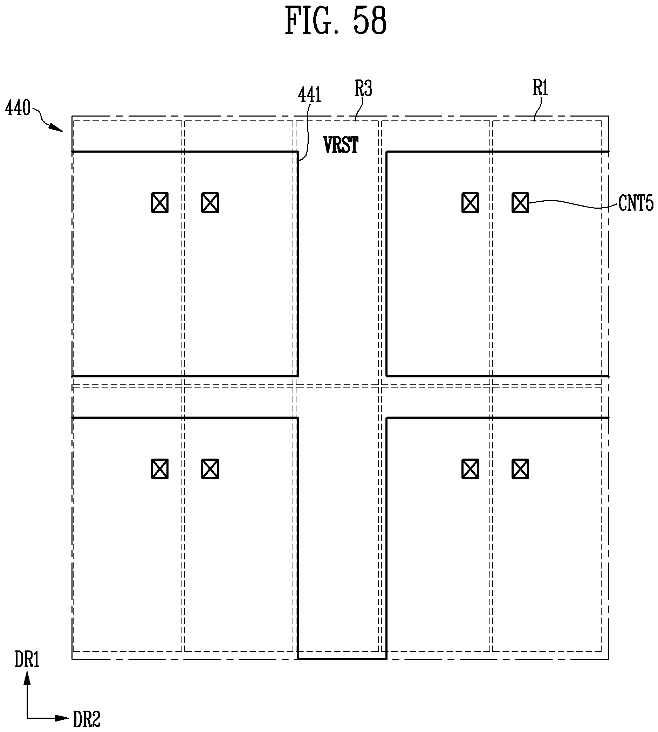

FIG. 57 illustrates a layout view of a sixth conductive layer of a display device according to one or more embodiments of the present disclosure. FIG. 58 illustrates a layout view of a seventh conductive layer of the display device of FIG. 57.

Because the display device according to the present embodiment may have the same or substantially the same configuration as the configuration of the display device in FIG. 1, except for the (6-5)-th conductive pattern 435, the (6-8)-th conductive pattern 438, and the (7-1)-th conductive pattern 441 in the third area R3, the same reference numbers and reference symbols are used to denote the same or substantially the same (or similar) constituent elements as those described above. Accordingly, redundant description may not be repeated.

Referring to FIG. 18, FIG. 33, FIG. 57, and FIG. 58, the display device may include a (6-8)-th conductive pattern 438. At least a portion of the (6-8)-th conductive pattern 438 may overlap with the first area R1. The (6-8)-th conductive pattern 438 may be connected to the (5-1)-th conductive pattern 421 and the (7-1)-th conductive pattern 441. In other words, the reset voltage VRST may be applied to the (6-8)-th conductive pattern 438.

The (6-8)-th conductive pattern 438 may form a mesh structure. For example, the (6-8)-th conductive pattern 438 may be disposed in one of the first area R1 adjacent to the third area R3 in the second direction DR2 and/or the first area R1 adjacent to the third area R3 in an opposite direction to the second direction DR2.

In an embodiment, the (6-5)-th conductive pattern 435 may not be connected to the (7-1)-th conductive pattern 441 in the third area R3. In other words, the fourth contact hole CNT4 connecting the (6-5)-th conductive pattern 435 to the (7-1)-th conductive pattern 441 may be disposed in the second area R2.

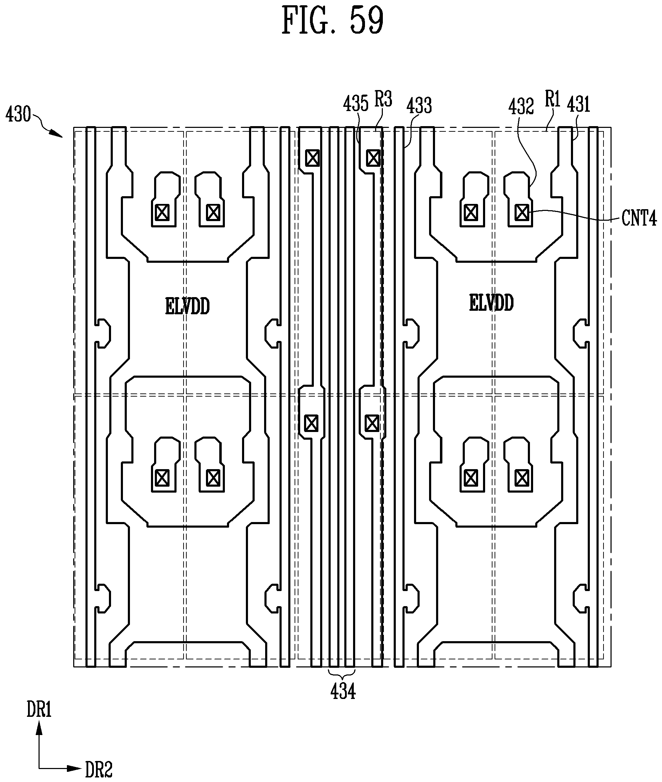

FIG. 59 illustrates a layout view of a sixth conductive layer of a display device according to one or more embodiments of the present disclosure.

Because the display device according to the present embodiment may have the same or substantially the same configuration as the configuration of the display device described above with reference to FIG. 1, except for the (6-5)-th conductive pattern 435 in the third area R3, the same reference numbers and reference symbols are used to denote the same or substantially the same (or similar) constituent elements as those described above. Accordingly, redundant description may not be repeated.

Referring to FIG. 1 to FIG. 3 and FIG. 59, the (6-3)-th conductive pattern 433 may be the data line DL to which the data voltage VDATA is applied. The (6-4)-th conductive pattern 434 may be the readout line RL to which the sensing signal is applied. The (6-5)-th conductive pattern 435 may be the reset voltage line to which the reset voltage VRST is applied.

The reset voltage line may be disposed between the data line DL and the readout line RL in the third area R3. For example, the (6-5)-th conductive pattern 435 may be disposed between the (6-3)-th conductive pattern 433 and the (6-4)-th conductive pattern 434. Accordingly, because the reset voltage line is disposed between the data line DL and the readout line RL, interference (e.g., the effect of coupling) between the data line DL and the readout line RL may be minimized or reduced.

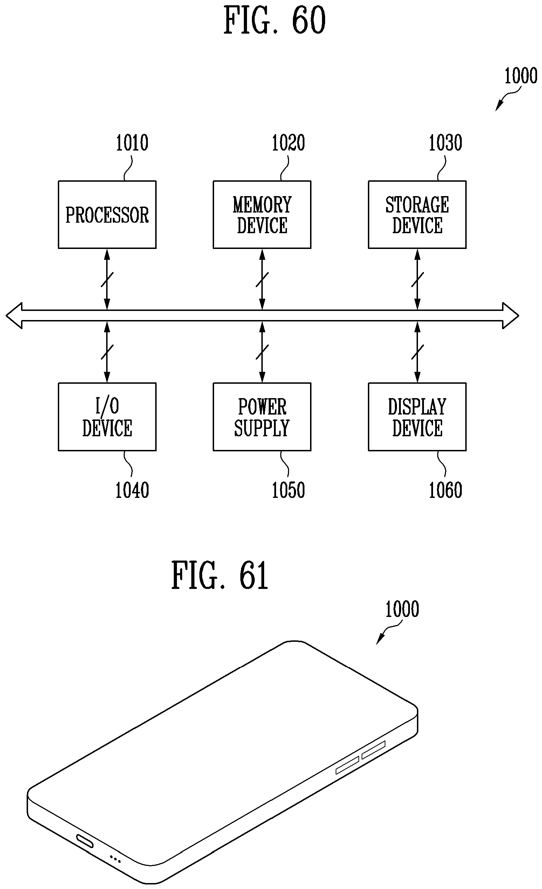

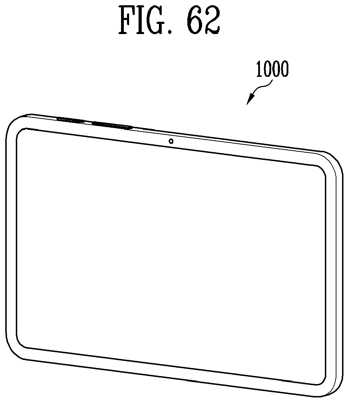

FIG. 60 illustrates a block diagram of an electronic device according to one or more embodiments of the present disclosure. FIG. 61 illustrates an example in which the electronic device of FIG. 60 is implemented as a smart phone. FIG. 62 illustrates an example in which the electronic device of FIG. 60 is implemented as a tablet PC.

Referring to FIG. 60 to FIG. 62, an electronic device 1000 may include a processor 1010, a memory device 1020, a storage device 1030, an input/output device 1040, a power supply 1050, and a display device 1060. For example, the display device 1060 may be the display device described above with reference to FIG. 1. In addition, the electronic device 1000 may further include several ports capable of communicating with a video card, a sound card, a memory card, a USB device, and the like, or communicating with other systems. In an embodiment, as shown in FIG. 61 and FIG. 62, the electronic device 1000 may be implemented as a smart phone or a tablet PC. However, the present disclosure is not limited thereto, and the electronic device 1000 is not limited thereto. For example, the electronic device 1000 may be implemented as a mobile phone, a video phone, a smart pad, a smart watch, a vehicle navigation device, a computer monitor, a laptop, a head mounted display device, or the like.

The processor 1010 may perform specific calculations or tasks. In some embodiments, the processor 1010 may be a micro-processor, a central processing unit, an application processor, or the like. The processor 1010 may be connected to other constituent elements through an address bus, a control bus, and a data bus. In some embodiments, the processor 1010 may also be connected to an extension bus, such as a peripheral component interconnect (PCI) bus.

The memory device 1020 may store data used for the operations of the electronic device 1000. For example, the memory device 1020 may include one or more suitable non-volatile memory devices, such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, and/or a ferroelectric random access memory (FRAM) device, and/or one or more suitable volatile memory devices, such as a dynamic random access memory (DRAM) device, a static random access memory (SRAM) device, and/or a mobile DRAM device.

The storage device 1030 may include a solid state drive (SSD), a hard disk drive (HDD), a CD-ROM, and/or the like.

The input/output device 1040 may include one or more suitable input devices, such as a keyboard, a keypad, a touch pad, a touchscreen, a mouse, and/or the like, and one or more suitable output devices, such as a speaker, a printer, and/or the like. In some embodiments, the display device 1060 may be included in the input/output device 1040.

The power supply 1050 may supply power used for the operation of the electronic device 1000. For example, the power supply 1050 may be a power management integrated circuit (PMIC).

The display device 1060 may display an image corresponding to visual information of the electronic device 1000. In this case, the display device 1060 may be an organic light emitting display device or a quantum dot light emitting display device, but the present disclosure is not limited thereto. The display device 1060 may be connected to the other constituent elements through the buses or other communication links.

Embodiments of the present disclosure described above may be applied to a display device and an electronic device including the same. For example, the embodiments of the present disclosure may be applied to a digital TV, a 3D TV, a mobile phone, a smart phone, a tablet computer, a VR device, a PC, a home electronic device, a laptop computer, a PDA, a PMP, a digital camera, a music player, a portable game console, a navigation device, and the like.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device (1060) comprising:
a display panel (100) comprising:
a display area (DA) comprising a sub-pixel (SP); and
a readout line (RL);
the display area including a sensing area (SA) comprising an optical sensor (LS) configured to provide a sensing signal corresponding to an amount of received light to the readout line (RL);
a readout circuit (600) configured to receive the sensing signal through the readout line (RL); and
a connection portion (FO) electrically connecting the readout line (RL) to the readout circuit (600),
wherein the sensing area (SA) comprises the sub-pixel and the optical sensor, and
the display area (DA) further comprises a non-sensing area (NSA) comprising the sub-pixel, and
wherein a connection line (CL1 to CL4) connecting the readout line (RL) and the connection portion (FO) to each other is located in the non-sensing area (NSA).

2. The display device (1060) of claim 1, wherein:
the readout line (RL) extends in a first direction;
the display area comprises a first display area adjacent to the connection portion (FO) in the first direction, and a second display area; and
the connection line (CL1 to CL4) connects the readout line (RL) of the second display area to the connection portion (FO).

3. The display device (1060) of claim 1 or 2, wherein:
the readout line (RL) extends in a first direction;
the connection line (CL1 to CL4) comprises a first connection line (CL1) and a second connection line (CL2);
the first connection line (CL1) extends in a second direction crossing the first direction, and is connected to the readout line (RL) through a first line contact hole; and
the second connection line (CL2) extends in the first direction, and is connected to the first connection line through a second line contact hole, and/or wherein the first connection line (CL1) and the second connection line (CL2) form a mesh structure.

4. The display device (1060) of claim 3, wherein:
the connection line (CL1 to CL4) further comprises a third connection line (CL3) and a fourth connection line (CL4);
the third connection line (CL3) extends in the second direction, and is connected to the second connection line through a third line contact hole; and
the fourth connection line (CL4) extends in the first direction, and is connected to the third connection line through a fourth line contact hole.

5. The display device (1060) of claim 4, wherein the readout line (RL) is located at the same layer as that of the second connection line (CL2), and/or.
wherein the first connection line (CL1) is located at the same layer as that of the third connection line (CL3).

6. The display device (1060) of any of the preceding claims, wherein:
the connection portion (FO) comprises a first connection area, and a second connection area spaced from the first connection area;
the readout line (RL) extends in a first direction;
the display area comprises a first display area adjacent to the first connection area and the second connection area in the first direction, and a second display area; and
the connection line (CL1 to CL4) connects the readout line (RL) of the second display area to the connection portion (FO).

7. The display device (1060) of any of the preceding claims, wherein a width of a first end of the connection portion (FO) adjacent to the display area (DA) is longer than a width of a second end of the connection portion (FO) connected to the readout circuit (600).

8. The display device (1060) of any of the preceding claims, wherein:
the sub-pixel (SP) comprises a light emitting element and a pixel driving circuit (PC);
the optical sensor (LS) comprises a light receiving element and a sensor driving circuit (LC);
the sensing area (SA) comprises a first area comprising the pixel driving circuit, and a second area adjacent to the first area and comprising the sensor driving circuit; and
the non-sensing area (NSA) comprises the first area comprising the pixel driving circuit, and a third area adjacent to the first area.

9. The display device (1060) of claim 8, wherein:
the pixel driving circuit (PC) comprises a first pixel transistor configured to generate a driving current;
the first pixel transistor comprises a portion of a conductive pattern (341); and
a width of the conductive pattern (341) in the third area is wider than a width of the conductive pattern (341) in the second area.

10. The display device (1060) of claim 8 or 9, wherein:
the pixel driving circuit comprises a second pixel transistor configured to write a data voltage in response to a write gate signal;
the second pixel transistor comprises a portion of a conductive pattern (341); and
a width of the conductive pattern (341) in the third area is wider than a width of the conductive pattern (341) in the second area.

11. The display device (1060) of claim any of claims 8 to 10, wherein:
the pixel driving circuit comprises a storage capacitor configured to store a data voltage;
the storage capacitor comprises a portion of a conductive pattern (341); and
at least a portion of the conductive pattern (341) is located in the third area, and/or wherein:
the sensor driving circuit is configured to be initialized with a reset voltage; and
a conductive pattern (341) configured to receive the reset voltage overlaps with at least a portion of the readout line (RL).

12. The display device (1060) of claim 11, wherein at least a portion of the conduction pattern (341) configured to receive the reset voltage overlaps with the first area, and/or
wherein the conductive pattern (341) configured to receive the reset voltage has a mesh structure.

13. The display device (1060) of any of claims 8 to claim 12, wherein:
the pixel driving circuit (PC) is configured to receive a data voltage through a data line;
the sensor driving circuit (LC) is configured to receive a reset voltage through a reset voltage line; and
the reset voltage line is located between the data line and the readout line (RL) in the third area.

14. The display device (1060) of any of the preceding claims, wherein a width of the connection line (CL1 to CL4) increases as a length of the connection line (CL1 to CL4) increases.

15. An electronic device (1000) comprising:
a processor (1010) configured to provide input image data to a display device (1060) of any of the preceding claims;
the display device (1060) configured to display an image based on the input image data; and
a power supply (1050) configured to supply power to the display device (1060).
